# EUROPÄISCHE PATENTSCHRIFT

(11) **EP 2 245 487 B1**
(45) Veröffentlichungstag und Bekanntmachung des Hinweises auf die Patenterteilung: **28.11.2012**
(21) Anmeldenummer: 09709712.5
(22) Anmeldetag: 11.02.2009
(51) Int. Cl.: G03F 7/00, G02B 5/32, G11B 7/26, G03H 1/02

(54) **Optische Elemente mit Gradientenstruktur sowie Verfahren zu dessen Herstellung**
Optical elements with gradient structure and method for production
Éléments optiques ayant une structure à gradient et procédé de production

(30) Priorität: 14.02.2008 DE 102008009332
(43) Veröffentlichungstag der Anmeldung: 03.11.2010
(73) Patentinhaber: Leibniz-Institut für Neue Materialien gemeinnützige GmbH, 66123 Saarbrücken (DE)
(72) Erfinder: DE OLIVEIRA, Peter, William, 66111 Saarbrücken (DE); VEITH, Michael, 66386 St.-Ingbert (DE); ROGIN, Peter, 66113 Saarbrücken (DE); LIN, Hechun, 66125 Saarbrücken (DE); GEERKENS, Marcus, 66287 Quierschied (DE)
(74) Vertreter: Gierlich, Johannes
(86) Internationale Anmeldenummer: PCT/EP2009/000952
(87) Internationale Veröffentlichungsnummer: WO 2009/100895

(56) Entgegenhaltungen:
- JP-A- 2007 052 382
- JP-A- 2008 026 492
- US-A1- 2008 311 380
- LIN HECHUN ET AL: "Ionic liquid as additive to increase sensitivity, resolution, and diffraction efficiency of photopolymerizable hologram material" APPLIED PHYSICS LETTERS, AIP, AMERICAN INSTITUTE OF PHYSICS, MELVILLE, NY, US, Bd. 93, Nr. 14, 6. Oktober 2008 (2008-10-06), Seiten 141101-141101, XP012111754 ISSN: 0003-6951

## Beschreibung

### Gebiet der Erfindung

Die Erfindung betrifft optische Elemente mit Gradientenstruktur, insbesondere für holographische Anwendungen, wobei die Gradientenstruktur durch einen Brechzahlgradienten gebildet wird, sowie ein Verfahren zur Herstellung dieser optischen Elemente mit Gradientenstruktur.

### Stand der Technik

Aus den US-Patenten 5,552,261 und 5,529,473 ist bekannt, die Diffusion von Monomeren, die gegenüber einer umgebenden flüssigen Matrix einen erhöhten oder verringerten Brechungsindex aufweisen, zur Erzeugung eines Brechzahlgradienten zu nutzen. Dieser bei Polymeren als Colburn-Haines-Effekt bekannte Effekt kann nach anschließender Polymerisation zu einem Produkt mit Brechzahlgradienten führen. Solche Polymere werden auch als Photopolymere bezeichnet.

Die US-Patente 3, 658, 526, 4, 959, 284, 4, 942, 112, 5,013,632, 5,098,803 (E. I. Du Pont Nemours) beschreiben die Herstellung von Photopolymeren über eine radikalische Polymerisation von Monomeren in einem festen Medium. Dies erfordert nicht nur den Ausschluss von Sauerstoff, sondern es kommt auch zu einer starken Schrumpfung des Materials durch die Polymerisation. Zur Beschichtung von Oberflächen ist außerdem der Zusatz eines Lösungsmittels nötig. Die Dicke des Materials ist daher bis zu 150 µm beschränkt.

US-Patent 6,482,551 beschreibt die Verwendung einer Matrix, welche in einem ersten Schritt polymerisiert wird. Die Monomere des Photopolymers werden erst in einem zweiten Schritt unter Bildung des eigentlichen Photopolymers polymerisiert. Da die Mischung der Monomere und der Matrix flüssig gewählt werden kann, ist zur Beschichtung von Oberflächen kein Zusatz eines Lösungsmittels nötig und es können Beschichtungen mit über einen Millimeter Dicke erzeugt werden. Die Monomere des Photopolymers und der Matrix dürfen dabei in keinem der Schritte miteinander reagieren. So verwendet US-Patent 5,453,340 für die Matrix kationisch polymerisierbare Monomere, wie Epoxide oder Oxetane, welche mit Bronsted oder Lewis-Säuren polymerisiert werden können, und radikalisch polymerisierbare Monomere für das Photopolymer. Dies führt erneut zu einer hohen Schrumpfung in den belichteten Bereichen. Das Material muss außerdem immer zweimal mit unterschiedlichen Wellenlängen belichtet werden.

In den Anmeldungen US 2003/0157414 und US 2005/0231773 werden beispielsweise Epoxide als Monomere für das Photopolymer verwendet, um die Schrumpfung zu verringern. Allerdings benötigen diese Zusammensetzungen eine höhere Energie zum Schreiben der optischen Information, d.h. beim Belichten, als die vorstehend beschriebenen Materialien, welche auf radikalische Polymerisation aufbauen.

Die US-Patente 7,022,392 und 6,969,578 beruhen nicht auf einer Polymerisation von Monomeren, sondern auf einer Photoisomerisierung einzelner Moleküle, welche zu einer lokalen Änderung des Brechungsindex führt. Daher kommt es bei ihnen nur zu geringen Veränderungen bei Belichtung. Allerdings erfordert dieses System spezielle Monomere.

Versuche, ein Photopolymer in einer anorganisch-organischen Matrix zur Verfügung zu stellen, beschreiben die US-Patente 6,268,089 und 7,163,769. Die Matrix wird im Sol-Gel-Verfahren hergestellt und das Photopolymer sowohl radikalisch als auch kationisch polymerisiert. Die erhaltenen Materialien zeigen keine großen Vorteile gegenüber den bereits bekannten Materialien.

Einen anderen Weg zur Erzeugung von Gradientenstrukturen beschreibt die Anmeldung US 2005/0101698. Dabei wird in einem Kompositmaterial ein Konzentrationsgradient von Nanopartikeln erzeugt und durch Polymerisation der diese umgebende Matrix fixiert. Dieses Verfahren erlaubt die Herstellung von Volumenhologrammen mit einer Brechungseffizienz von 90 %. Allerdings ist die Dicke der Schichten begrenzt und das Material zeigt eine hohe Schrumpfung wegen der radikalischen Polymerisation.

Zusammenfassend ist festzustellen, dass die Entwicklung von Photopolymeren in den letzten Jahren große Fortschritte zu verzeichnen hatte. Dennoch besitzen die bekannten Systeme noch einige Nachteile. So sind die verwendeten Systeme nicht empfindlich genug, um eine sehr scharfe Modulation der Brechzahl zu ermöglichen. Dabei beinhaltet die Empfindlichkeit die zur Polymerisation benötigte Lichtstärke, als auch die zur Herstellung der Gradientenstruktur benötigte Belichtungsdauer. Beide begrenzen die Auflösung und Brechungseffizienz der hergestellten Gradientenstrukturen. Gleichzeitig spielt auch die im Material erzielte Bandbreite der Brechzahlmodulation eine wichtige Rolle. Beide genannten Parameter beispielsweise begrenzen die minimale Schichtdicke des Materials, mit dem die Herstellung von optischen Gradientenstrukturen noch möglich ist.

Da optische Gradientenstrukturen heutzutage in vielen Bereichen mit höchst unterschiedlichen Anforderungen, beispielsweise bezüglich mechanischer Flexibilität, Dicke und Stabilität, eingesetzt werden, ist eine hohe Variabilität der eingesetzten Komponenten von großer Bedeutung.

### Aufgabe

Aufgabe der Erfindung ist es, ein einfaches, universell anwendbares und kostengünstiges Verfahren zur Herstellung von optischen Elementen mit Gradientenstruktur bereitzustellen, welche die angegebenen Nachteile des Stands der Technik überwindet.

### Lösung

Diese Aufgabe wird durch die Erfindungen mit den Merkmalen der unabhängigen Ansprüche gelöst. Vorteilhafte Weiterbildungen der Erfindungen sind in den Unteransprüchen gekennzeichnet. Der Wortlaut sämtlicher Ansprüche wird hiermit durch Bezugnahme zum Inhalt dieser Beschreibung gemacht. Die Erfindung umfasst auch alle sinnvollen und insbesondere alle erwähnten Kombinationen von unabhängigen und/oder abhängigen Ansprüchen.

Im erfindungsgemäßen Verfahren zur Herstellung optischer Elemente mit Gradientenstruktur, insbesondere für holographische Anwendungen, wird die Gradientenstruktur durch einen Brechzahlgradienten gebildet, der mit folgenden Schritten hergestellt wird:
(a) Herstellen einer Zusammensetzung durch Mischen von einem oder mehreren polymerisierbaren oder polykondensierbaren organischen Monomeren und mindestens einer ionischen Flüssigkeit;
(b) Erzeugen einer Potentialdifferenz zur gerichteten Diffusion der Monomere unter Bildung eines Brechzahlgradienten durch Induzierung einer lokalen Polymerisation oder Polykondensation.

Im Folgenden werden einzelne Verfahrensschritte näher beschrieben. Die Schritte müssen nicht notwendigerweise in der angegebenen Reihenfolge durchgeführt werden, und das zu schildernde Verfahren kann auch weitere, nicht genannte Schritte aufweisen.

Bei der Potentialdifferenz wird vorzugsweise eine chemische Potentialdifferenz erzeugt, beispielsweise analog dem vorstehend beschriebenen Colburn-Haines-Effekt, der auf folgendem Mechanismus beruht: Bei einer lokalen (z. B. thermisch und / oder photochemisch induzierten) Polymerisation oder Polykondensation von Spezies mit polymerisierbaren oder polykondensierbaren Gruppen, wie z. B. Kohlenstoff-Kohlenstoff-Mehrfachbindungen oder Epoxid-Ringen, führt die Polymerisation oder Polykondensation zu einer Verarmung an polymerisierbaren oder polykondensierbaren Gruppen in den Bereichen, in denen die Polymerisation oder Polykondensation stattfindet. Dies führt zu einer gerichteten Diffusion von Monomeren mit noch nicht reagierten polymerisierbaren oder polykondensierbaren Gruppen in die (erwärmten bzw. belichteten) Bereiche, in denen die Polymerisation oder Polykondensation stattfindet, bzw. stattgefunden hat, um die chemische Potentialdifferenz auszugleichen. Diese Monomere stehen in diesen Bereichen zur Polymerisation zur Verfügung. Dies führt in den erwärmten bzw. belichteten Bereichen zu einer Veränderung der optischen Dichte und somit zu einer lokalen Erhöhung oder Erniedrigung der Brechzahl.
Die vorstehend verwendeten Ausdrücke "Polymerisation" und "polymerisierbar" schließen auch die Polyaddition und polyadditionsfähige Gruppen ein.

Überraschenderweise wurde nun gefunden, dass durch die Zugabe von mindestens einer ionischen Flüssigkeit die Ausbildung eines Brechzahlgradienten deutlich verbessert und beschleunigt werden kann. Dies wird nachstehend noch ausführlicher behandelt.

Die chemische Potentialdifferenz wird vorzugsweise durch Belichtung oder Elektronenbestrahlung, insbesondere durch holographische oder lithographische Techniken oder über die Maskaligner-Technik, erzeugt. Durch selektive Bestrahlung oder Belichtung der Zusammensetzung kann z. B. an lokalen Stellen gezielt eine Polymerisation oder Polykondensation ausgelöst werden, die zu einer chemischen Potentialdifferenz führt, die wiederum zur gerichteten Diffusion der Monomere und zur Ausbildung eines Brechzahlgradienten führt.

Ohne an ein bestimmtes System gebunden zu sein, ließe es sich auch so erklären, dass durch die lokale Polymerisation oder Polykondensation eine Komponente mit einer bestimmten Brechzahl bildet, bzw. ihre Konzentration dort erhöht, während im Gegenzug die Brechzahl der anderen Bereiche durch die Diffusion der Monomere ebenfalls verändert wird.

In einer starken Vereinfachung kann das System vor dem Anlegen der Potentialdifferenz auch als eine homogene Mischung von zwei Komponenten mit unterschiedlichen Brechzahlen betrachtet werden, wobei darunter auch Vorläuferverbindungen für eine Komponente zu verstehen sind. Durch die gerichtete Diffusion kommt es zu lokalen Veränderungen in den Anteilen der beiden Komponenten. Diese verursacht den beobachteten Brechzahlgradienten.

Daraus folgt, dass, wie vorstehend erwähnt, die Veränderung der Brechzahl immer in Relation zu den Bereichen ohne Polymerisation oder Polykondensation zu sehen ist. Entscheidend ist der daraus resultierende Unterschied in der Brechzahl. Welcher Bereich eine höhere, bzw. niedrigere Brechzahl aufweist, kann beispielsweise durch die Wahl der Monomere und der ionischen Flüssigkeit oder anderer Komponenten bestimmt werden.

Für die Belichtungsverfahren werden bevorzugt UV-Licht oder Laserlicht eingesetzt. Bei Verwendung eines Lasers als Lichtquelle können über holographische Techniken sowohl periodische Gitterstrukturen als auch Fresnelstrukturen hergestellt werden. Die durch Interferenz auftretenden Intensitätsprofile wirken als Polymerisationssenken. Für die besonders bevorzugte holographische Belichtung können z. B. mittels Zwei-Wellenmischen phasenmodulierte Volumenhologramme als Transmissions- oder Reflexionshologramme hergestellt werden (Kogelnik 1969).

Als kohärente Lichtquelle kann z. B. ein Argon-lonen-Laser dienen.

Nach der Herstellung der Gradientenstruktur können die nicht polymerisierten oder nicht polykondensierten Monomere durch eine nicht-lokale Induktion einer Polymerisation oder Polykondensation, beispielsweise eine nicht intensitätsmodulierte Belichtung, gleichmäßig abreagieren. Da dabei keinerlei gerichtete Diffusion mehr auftritt, kommt es maximal zu einer geringen Abschwächung des bereits erzeugten Brechzahlgradienten. Allerdings kann dadurch die Haltbarkeit der hergestellten Gradientenstrukturen deutlich verbessert werden.

In einer vorteilhaften Weiterbildung der Erfindung, enthält die Zusammensetzung folgende Komponenten:
(a) 4,9 bis 95,9 Gew.-% eines oder mehreren polymerisierbaren oder polykondensierbaren organischen Monomer(en),
(b) 0,1 bis 50 Gew.-% mindestens einer ionischen Flüssigkeit,
(c) 0 bis 5 Gew.-% eines oder mehrerer Additiv(e) ausgewählt aus thermischen oder photochemischen Vernetzungsinitiatoren, Sensibilisierungsmitteln, Netzhilfsmitteln, Haftvermittlern, Verlaufsmitteln, Antioxidationsmitteln, Stabilisatoren, Farbstoffen, photochromen oder thermochromen Verbindungen.

Mit Vorteil sind alle Komponenten der Zusammensetzung miteinander mischbar. Bevorzugt liegen mindestens zwei der Komponenten in einer gemeinsamen Phase vor, besonders bevorzugt die ionische(n) Flüssigkeit(en) und die Monomer(e), ganz besonders bevorzugt liegen alle Bestandteile in einer gemeinsamen Phase vor.

Der Gehalt an mindestens einer ionischen Flüssigkeit liegt mit Vorteil zwischen 1 bis 50 Gew.-%, bevorzugt zwischen 15 und 50 Gew.-%, besonders bevorzugt zwischen 20 und 40 Gew.-%, ganz besonders bevorzugt zwischen 20 und 30 Gew.-%.

Das polymerisierbare oder polykondensierbare organische Monomer oder die polymerisierbaren oder polykondensierbaren organischen Monomere können prinzipiell jede dem Fachmann bekannte Spezies umfassen, die zur Polymerisation oder Polykondensation geeignet ist. So können beispielsweise polymerisierbare oder polykondensierbare Monomere, Oligomere oder Prepolymere verwendet werden.

Die Monomere können auch mehr als eine polymerisierbare oder polykondensierbare Gruppe enthalten. Bevorzugt werden Monomere, welche transparente Polymere ergeben.

Spezielle Beispiele für polymerisierbare oder polykondensierbare organische Monomere sind (Meth)acrylsäure, (Meth)acrylsäureester, (Meth)acrylnitril, Styrol und Styrol-Derivate, Alkene (z. B. Ethylen, Propylen, Buten, Isobuten), halogenierte Alkene (z. B. Tetrafluorethylen, Chlortrifluorethylen, Vinylchlorid, Vinylfluorid, Vinylidenfluorid, Vinylidenchlorid), Vinylacetat, Vinylpyrrolidon, Vinylcarbazol und Mischungen davon. Auch mehrfach ungesättigte Monomere können vorhanden sein, z. B. Butadien und (Meth)acrylsäureester von Polyolen (z. B. Diolen).

Bevorzugt sind Acrylate oder Methacrylate, insbesondere Methylmethacrylat, ein Diol(meth)acrylat oder ein Diol-di (meth)acrylat, wie z. B. Hexandioldimethacrylat (HDMA), Hexandioldiacrylat, Dodecandioldimethacrylat und Dodecandioldiacrylat.

Besonders bevorzugt sind auch Acrylate oder Methacrylate mit einer oder mehreren polymerisierbaren Gruppen, sogenannte Vernetzer, welche mit Oligomeren und / oder Polymeren modifiziert sind. Ganz besonders bevorzugt werden Monomere mit einem Molgewicht von bis zu 5000 g/mol, bevorzugt bis zu 1500 g/mol, besonders bevorzugt zwischen 27 g/mol und 600 g/mol. Beispiele für solche Monomer sind Polyethylenglycoldi(meth)acrylate (PEGDMA), Polyethylenglycol(meth)acrylate (PEGMA), Tetramethelenglycoldi(meth)acrylate (TMGDMA), Bisphenyl-A-di(meth)acrylate (BPADMA) oder Tetraethylenglycol-di(meth)acrylate (TEGDMA).

Unter (Meth)acrylaten wird erfindungsgemäß sowohl das jeweilige Acrylat als auch das jeweilige Methylacrylat verstanden, dies gilt analog für (Meth)acrylsäure oder (Meth)acrylsäureester. Die Zusammensetzung enthält erfindungsgemäß mindestens eine ionische Flüssigkeit. Als solche werden Salze, meistens mit mindestens einer organischen Komponente, bezeichnet, welche bei Temperaturen von unter 100 °C, vorzugsweise Raumtemperatur, flüssig sind. Durch geeignete Wahl der Kombination von Kationen und Anionen ist es möglich, die Eigenschaften der ionischen Flüssigkeit entsprechend den gewünschten Eigenschaften, wie beispielsweise Viskosität, Löslichkeit der Komponenten, thermische oder photochemische Stabilität, Dichte, Schmelzpunkt, Polarität oder Hydrophobie in einem großen Bereich einzustellen (Wasserscheid et al. 2003).

Da die meisten ionischen Flüssigkeiten weder entzündlich sind noch einen messbaren Dampfdruck besitzen, werden sie bereits in vielen Reaktionen als Ersatz oder Zusatz für herkömmliche Lösungsmittel eingesetzt, auch für Polymerisationsprozesse (Kubisa et al. 2005; Winterton 2006), beispielsweise für die Polymerisation von Olefinen, oxidative Polymerisationen, enzymatische Polymerisationen, radikalische Polymerisationen, übergangsmetallkatalysierte Polymerisationen und "reverse atom transfer radical"-Polymerisationen. Bei den radikalischen Polymerisationen wurde in ionischen Flüssigkeiten eine deutlich verbesserte Polymerisationsrate festgestellt. Verglichen mit herkömmlichen Lösungsmitteln werden mit ionischen Flüssigkeiten höhere Molgewichte der erhaltenen Polymere und bessere Umwandlung der Monomere erreicht. (Hong et al, 2002; Zhang et al. 2002; Strehmel et al. 2006).

Bevorzugt entsprechen die ionische Flüssigkeit oder die ionischen Flüssigkeiten der allgemeinen Formel K⁺A⁻.

Die Kationen (K⁺) sind bevorzugt aus der Gruppe der Ammonium-, Phosphonium-, Uronium-, Thiouronium-, Guanidiniumkationen oder heterocyclischen Kationen ausgewählt.

Als Ammonium-Kationen können Kationen entsprechend der allgemeinen Formel (1)

[NR₄]⁺

gewählt werden, wobei
R jeweils unabhängig voneinander H, mit der Maßgabe, dass minimal zwei Substituenten R in Formel (1) H sind,
OR`, NR'₂, mit der Maßgabe, dass maximal ein Substituent R in Formel (1) OR`, NR'₂ ist,
geradkettiges oder verzweigtes Alkyl mit 1-20 C-Atomen, geradkettiges oder verzweigtes Alkyl mit 2-20 C-Atomen und einer oder mehreren Doppelbindungen,
geradkettiges oder verzweigtes Alkyl mit 2-20 C-Atomen und einer oder mehreren Dreifachbindungen,
gesättigtes, teilweise oder vollständig ungesättigtes Cycloalkyl mit 3-7 C-Atomen, das mit Alkylgruppen mit 1-6 C-Atomen substituiert sein kann,
wobei ein oder mehrere R teilweise oder vollständig mit Halogenen, oder teilweise mit -OH, -OR', -CN, -C(O)OH, -C(O)NR'₂, -SO₂NR'₂, -SO₂OH, -NO₂ substituiert sein können, und wobei ein oder mehrere nicht benachbarte und nicht α-ständige Kohlenstoffatome des R durch Atome und / oder Atomgruppierungen ausgewählt aus der Gruppe -O-, -S-, -S(O)-, -SO₂-, -C(O)-, -C(O)O-, -N⁺R'₂-, -P(O)R'O-, -C(O)NR'-, -SO₂NR'-, -OP(O)R'O-, -P(O)(NR'₂)NR'-, -PR'₂=N- oder -P(O)R'- ersetzt sein können mit R'=H, nicht, teilweise, oder perfluoriertes C₁- bis C₆-Alkyl,
C₃- bis C₇-Cycloalkyl, unsubstituiertes oder substituiertes Phenyl sein kann.

Als Phosphonium-Kationen können Kationen entsprechend der allgemeinen Formel (2)

[PR²₄]⁺

gewählt werden, wobei
R jeweils unabhängig voneinander
H, OR', NR'₂,
geradkettiges oder verzweigtes Alkyl mit 1-20 C-Atomen, geradkettiges oder verzweigtes Alkyl mit 2-20 C-Atomen und einer oder mehreren Doppelbindungen,
geradkettiges oder verzweigtes Alkyl mit 2-20 C-Atomen und einer oder mehreren Dreifachbindungen,
gesättigtes, teilweise oder vollständig ungesättigtes Cycloalkyl mit 3-7 C-Atomen, das mit Alkylgruppen mit 1-6 C-Atomen substituiert sein kann, bedeutet,
wobei ein oder mehrere R² teilweise oder vollständig mit Halogenen, oder teilweise mit -OH, -OR', -CN, -C(O)OH, -C(O)NR'₂, -SO₂NR'₂, -SO₂OH, -NO₂ substituiert sein können, und wobei ein oder mehrere nicht benachbarte und nicht α-ständige Kohlenstoffatome des R² durch Atome und / oder Atomgruppierungen ausgewählt aus der Gruppe -O-, -S-, -S(O)-, -SO₂-, -C(O)-, -C(O)O-, -N+R'₂-, -P(O)R'O-, -C(O)NR'-, -SO₂NR'-, -OP(O)R'O-, -P(O) (NR'₂)NR'-, -PR'₂=N- oder -P(O)R'- ersetzt sein können mit R'=H, nicht, teilweise, oder perfluoriertes C₁- bis C₆-Alkyl, C₃- bis C₇-Cycloalkyl, unsubstituiertes oder substituiertes Phenyl.

Als Uronium-Kationen können Kationen entsprechend der allgemeinen Formel (3)

[(R³R⁴N) -C (=OR⁵) (NR⁶R⁷)]⁺

gewählt werden, wobei
R³ bis R⁷ jeweils unabhängig voneinander
H, wobei H für R⁵ ausgeschlossen wird,
geradkettiges oder verzweigtes Alkyl mit 1-20 C-Atomen, geradkettiges oder verzweigtes Alkyl mit 2-20 C-Atomen und einer oder mehreren Doppelbindungen,
geradkettiges oder verzweigtes Alkyl mit 2-20 C-Atomen und einer oder mehreren Dreifachbindungen,
gesättigtes, teilweise oder vollständig ungesättigtes Cycloalkyl mit 3-7 C-Atomen, das mit Alkylgruppen mit 1-6 C-Atomen substituiert sein kann, bedeutet,
wobei ein oder mehrere der R³ bis R⁷ teilweise oder vollständig mit Halogenen, oder teilweise mit -OH, -OR', -CN, -C(O)OH, -C(O)NR'₂, -SO₂NR'₂, -SO₂OH, -NO₂ substituiert sein können, und wobei ein oder mehrere nicht benachbarte und nicht α-ständige Kohlenstoffatome von R³ bis R⁷ durch Atome und / oder Atomgruppierungen ausgewählt aus der Gruppe -O-,
   -S-, -S(O)-, -SO₂-, -C(O)-, -C(O)O-, -N⁺R'₂-, -P(O)R'O-, -C(O)NR'-, -SO₂NR'-, -OP(O)R'O-, -P(O)(NR'₂)NR'-, -PR'₂=N- oder -P(O)R'- ersetzt sein können mit R'=H, nicht, teilweise, oder perfluoriertes C₁- bis C₆-Alkyl, C₃- bis C₇-Cycloalkyl, unsubstituiertes oder substituiertes Phenyl.

Als Thiouronium-Kationen können Kationen entsprechend der allgemeinen Formel (4)

[(R³R⁴N) -C(=SR⁵) (NR⁶R⁷)]⁺

gewählt werden, wobei
R³ bis R⁷ jeweils unabhängig voneinander
H, wobei H für R⁵ ausgeschlossen wird,
geradkettiges oder verzweigtes Alkyl mit 1-20 C-Atomen, geradkettiges oder verzweigtes Alkyl mit 2-20 C-Atomen und einer oder mehreren Doppelbindungen,
geradkettiges oder verzweigtes Alkyl mit 2-20 C-Atomen und einer oder mehreren Dreifachbindungen,
gesättigtes, teilweise oder vollständig ungesättigtes Cycloalkyl mit 3-7 C-Atomen, das mit Alkylgruppen mit 1-6 C-Atomen substituiert sein kann, bedeutet,
wobei ein oder mehrere der R³ bis R⁷ teilweise oder vollständig mit Halogenen, oder teilweise mit -OH, -OR', -CN, -C(O)OH, -C(O)NR'₂, -SO₂NR'₂, -SO₂OH, -NO₂ substituiert sein können, und wobei ein oder mehrere nicht benachbarte und nicht α-ständige Kohlenstoffatome von R³ bis R⁷ durch Atome und / oder Atomgruppierungen ausgewählt aus der Gruppe -O-,
   -S-, -S(O)-, -SO₂-, -C(O)-, -C(O)O-, -N⁺R'₂-, -P(O)R'O-, -C(O)NR'-, -SO₂NR'-, -OP(O)R'O-, -P(O)(NR'₂)NR'-, -PR'₂=N- oder -P(O)R'- ersetzt sein können mit R'=H, nicht, teilweise, oder perfluoriertes C₁- bis C₆-Alkyl, C₃- bis C₇-Cycloalkyl, unsubstituiertes oder substituiertes Phenyl.

Als Guanidinium-Kationen können Kationen entsprechend der allgemeinen Formel (5)

[C(NR⁸R⁹) (NR¹⁰R¹¹) (NR¹²R¹³)]⁺

gewählt werden, wobei
R⁸ bis R¹³ jeweils unabhängig voneinander
H, -CN, -NR'₂, -OR',
geradkettiges oder verzweigtes Alkyl mit 1-20 C-Atomen, geradkettiges oder verzweigtes Alkyl mit 2-20 C-Atomen und einer oder mehreren Doppelbindungen,
geradkettiges oder verzweigtes Alkyl mit 2-20 C-Atomen und einer oder mehreren Dreifachbindungen,
gesättigtes, teilweise oder vollständig ungesättigtes Cycloalkyl mit 3-7 C-Atomen, das mit Alkylgruppen mit 1-6 C-Atomen substituiert sein kann, bedeutet,
wobei ein oder mehrere der R⁸ bis R¹³ teilweise oder vollständig mit Halogenen, oder teilweise mit -OH, -OR', -CN, -C(O)OH, -C(O)NR'₂, -SO₂NR'₂, -SO₂OH, -NO₂ substituiert sein können, und wobei ein oder mehrere nicht benachbarte und nicht α-ständige Kohlenstoffatome von R⁸ bis R¹³ durch Atome und / oder Atomgruppierungen ausgewählt aus der Gruppe -O-,
   -S-, -S(O)-, -SO₂-, -C(O)-, -C(O)O-, -N⁺R'₂-, -P(O)R'O-, -C(O)NR`-, -SO₂NR'-, -OP(O)R'O-, -P(O)(NR'₂)NR'-, -PR'₂=N- oder -P(O)R'- ersetzt sein können mit R'=H, nicht, teilweise, oder perfluoriertes C₁- bis C₆-Alkyl, C₃- bis C₇-Cycloalkyl, unsubstituiertes oder substituiertes Phenyl sein kann.

Als heterocyclische Kationen können Kationen entsprechend der allgemeinen Formel (6)

[HetN]⁺

gewählt werden, wobei
[HetN]⁺ ausgewählt ist aus der Gruppe enthaltend Imidazolium, 1H-Pyrazolium, 3H-Pyrazolium, 4H-Pyrazolium, 1-Pyrazolinium, 2-Pyrazolinium, 3-Pyrazolinium, 2,3-Dihydro-Imidazolinium, 4,5-Dihydroimidazolinium, 2,5-Dihydro-Imidazolinium, Pyrrolidinium, 1,2,4-Triazolium, 1,2,3-Triazolium, Pyridinium, Pyridazinium, Pyrimidinium, Piperidinium, Morpholinium, Pyrazinimium, Thiazolium, Oxazolium, Indolium, Chinolinium, Isochinolinium, Chinoxalinium und Indolinium. Die Kationen können verschiedene oder gleiche Substituenten entsprechend der oben für R⁸ angegebenen Substitutionen aufweisen.

[HetN]⁺ sind bevorzugt Verbindungen der allgemeinen Formel (7) 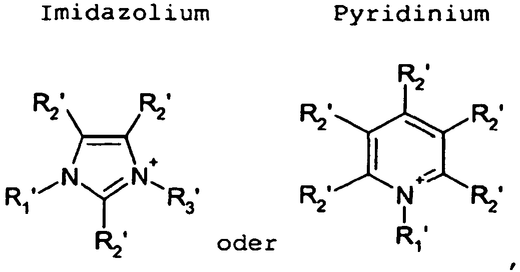 wobei die Substituenten R₁' bis R₃' jeweils unabhängig voneinander
H, -CN, -NR'₂, -OR', P(O)R'₂, -P(O)(OR')₂, -P(O)N_{R}'₂)₂, -C(O)R', -C(O)OR',
geradkettiges oder verzweigtes Alkyl mit 1-20 C-Atomen, geradkettiges oder verzweigtes Alkyl mit 2-20 C-Atomen und einer oder mehreren Doppelbindungen,
geradkettiges oder verzweigtes Alkyl mit 2-20 C-Atomen und einer oder mehreren Dreifachbindungen,
gesättigtes, teilweise oder vollständig ungesättigtes Cycloalkyl mit 3-7 C-Atomen, das mit Alkylgruppen mit 1-6 C-Atomen substituiert sein kann,
gesättigtes, teilweise oder vollständig Heteroaryl, Heteroaryl-C₁-C₆-alkyl oder Aryl-C₁-C₆-alkyl bedeutet,
wobei die Substituenten R₁', R₂' und / oder R₃' zusammen auch ein Ringsystem bilden können,
wobei ein oder mehrere der Substituenten R₁' bis R₃' teilweise oder vollständig mit Halogenen, oder teilweise mit -OH, -OR', -CN, -C(O)OH, -C(O)NR'₂, -SO₂NR'₂, -SO₂OH, -NO₂ substituiert sein können, und wobei ein oder mehrere nicht benachbarte und nicht am Heteroatom gebundene Kohlenstoffatome der Substituenten R₁' bis R₃' durch Atome und / oder Atomgruppierungen ausgewählt aus der Gruppe -O-, -S-, -S(O)-, -SO₂-, -C(O)-, -C(O)O-, -N⁺R'₂-, -P(O)R'O-, -C(O)NR'-, -SO₂NR'-, -OP(O)R'O-, -P(O)(NR'₂)NR'-, -PR'₂=N- oder -P(O)R'- ersetzt sein können mit R`=H, nicht, teilweise, oder perfluoriertes C₁- bis C₆-Alkyl, C₃- bis C₇-Cycloalkyl, unsubstituiertes oder substituiertes Phenyl.

Unter vollständig ungesättigten Substituenten werden im Sinne der vorliegenden Erfindung auch aromatische Substituenten verstanden.

Als Substituenten R und R² bis R¹³ der Verbindungen der Formeln (1) bis (5) kommen neben Wasserstoff bevorzugt in C₁- bis C₂₀-, insbesondere C₁- bis C₁₄-Alkylgruppen, und gesättigte oder ungesättigte, d.h. auch aromatische, C₃- bis C₇-Cycloalkylgruppen, die mit C₁- bis C₆-Alkylgruppen substituiert sein können, insbesondere Phenyl.

Die Substituenten R und R² sind bevorzugt Methyl, Ethyl, n-Propyl, Isopropyl, n-Butyl, sek.-Butyl, tert.-Butyl, Pentyl, Hexyl, Octyl, Decyl oder Tetradecyl.

Die Substituenten R³ bis R¹³ sind jeweils unabhängig voneinander bevorzugt eine geradkettige oder verzweigte Alkylgruppe mit 1 bis 10 C-Atomen. Die Substituenten R³ und R⁴, R⁶ und R⁷, R⁸ und R⁹, R¹⁰ und R¹¹ und R¹² und R¹³ in den Verbindungen der Formeln (3) bis (5) können dabei gleich und verschieden sein. Besonders bevorzugt sind R³ bis R¹³ jeweils unabhängig voneinander Methyl, Ethyl, n-Propyl, Isopropyl, n-Butyl, sek.-Butyl, tert.-Butyl, Pentyl, Hexyl, Octyl, Phenyl, Cyclohexyl oder Benzyl.

Als Substituenten R₁' bis R₃' von Verbindungen der Formel (7) kommen neben Wasserstoff bevorzugt in C₁- bis C₂₀-, insbesondere C₁- bis C₁₂-Alkylgruppen, und gesättigte oder ungesättigte, d.h. auch aromatische, C₃- bis C₇-Cycloalkylgruppen, die mit C₁- bis C₆-Alkylgruppen substituiert sein können, insbesondere Phenyl.

Die Substituenten R₁` bis R₃' sind jeweils unabhängig voneinander bevorzugt Methyl, Ethyl, n-Propyl, Isopropyl, n-Butyl, sek.-Butyl, tert.-Butyl, Pentyl, Hexyl, Octyl, Phenyl, Cyclohexyl oder Benzyl, besonders bevorzugt Methyl, Ethyl, n-Propyl, n-Butyl, sek.-Butyl, tert.-Butyl oder Hexyl.

Die Substituenten R₂' und R₃' sind jeweils unabhängig voneinander besonders bevorzugt Wasserstoff, Methyl, Ethyl, *n*-Propyl, Isopropyl, *n*-Butyl, *sek*.-Butyl, *tert*.-Butyl, Pentyl, Hexyl, Cyclohexyl oder Benzyl.

Für weitere erfindungsgemäße Kationen sei auf die deutsche Patentanmeldung DE 10 2005 025 315 A1 verwiesen, worauf hiermit explizit Bezug genommen wird.

Die Anionen (A⁻) sind bevorzugt aus der Gruppe der Halogenide, Acetate, Phosphate, Phosphinate, Aluminate, Borate, Sulfate, Sulfonate, Imide, Amide oder Cyanate ausgewählt.

Im Falle der Halogenide werden Chloride, Bromide, Iodide und Polyhalogenide, wie I₃⁻ oder Br₃⁻ bevorzugt.

Im Falle der Phosphate werden fluorierte Phosphate, wie Hexafluorophosphate oder tris(pentafluoroethyl)trifluorophosphat oder ein- oder zweifach alkylierte und / oder benzylierte Phosphate, gegebenenfalls vollständig oder teilweise substituiert, insbesondere vollständig oder teilweise fluoriert bevorzugt.

Im Falle der Borate werden Tetrahalogenidborate, wie beispielsweise [BF₄]⁻, oder anionische Borkomplexe mit 1,2-dicarbonylverbindungen, wie beispielsweise Bisoxalato(2⁻)-borate bevorzugt.

Im Falle der Sulfate werden Hydrogensulfate oder einfach alkylierte oder benzylierte Sulfate, gegebenenfalls vollständig oder teilweise substituiert, insbesondere vollständig oder teilweise fluoriert bevorzugt.

Im Falle der Sulfonate werden Triflate und Tosylate und ihre Derivate, wie beispielsweise Trifluormethansulfonate, *para-*Toluolsulfonate oder Mesitylsulfonate bevorzugt.

Im Falle der Imide werden Imide von Sulfonaten, wie beispielsweise Bis(trifluoromethansulfonyl)imid bevorzugt.

Im Falle der Amide wird Dicyanamid bevorzugt.

Besonders bevorzugte ionische Flüssigkeiten mit der allgemeinen Formel [K⁺A⁻] sind 1-n-Butyl-3-methylimidazolium-chlorid ([BMIM]Cl), 1-n-Hexyl-3-methylimidazolium-chlorid ([HMIM]Cl), 1-Methyl-3-n-octylimidazolium-chlorid, ([OMIM]Cl), 1-n-Butyl-3-methylimidazolium-tetrafluoroborat ([BMIM][BF₄]), 1-n-Hexyl-3-methylimidazolium-tetrafluoroborat ([HMIM][BF₄]), 1-Methyl-3-n-octylimidazolium-tetrafluoroborat, ([OMIM][BF₄]), 1-n-Butyl-3-methylimidazolium-hexafluorophosphat ([BMIM][PF₆]), 1-n-Hexyl-3-methylimidazolium-hexafluorophosphat ([HMIM][PF₆]) oder 1-Methyl-3-n-octylimidazolium-hexafluorophosphat, ([OMIM][PF₆]). Viele ionischen Flüssigkeiten sind kommerziell erhältlich, beispielsweise von Merck (Darmstadt, DE), Sigma-Aldrich (St. Louis, US) oder Solvent Innovation (Köln, DE).

Wie oben erwähnt, wurde nun überraschenderweise gefunden, dass die ionischen Flüssigkeiten eine sehr scharfe und genaue Ausbildung des Brechzahlgradienten ermöglichen. Darüber hinaus wird die Glasübergangstemperatur des entstehenden Polymers gesenkt und die Flexibilität der hergestellten optischen Elemente erhöht. Desweiteren tritt bei den auf diese Weise hergestellten optischen Elementen praktisch keine Schrumpfung in den belichteten Bereichen auf. Dadurch sind auch sehr dicke optische Elemente möglich. Beide Eigenschaften erlauben daher die Herstellung von besonders dünnen, sowie auch von besonders dicken optischen Elementen.

Die Zusammensetzung kann noch zusätzlich für optische Systeme übliche Additive enthalten. Beispiele sind Weichmacher, thermische oder photochemische Vernetzungsinitiatoren, Sensibilisierungsmittel, Netzhilfsmittel, Haftvermittler, Verlaufsmittel, Antioxidationsmittel, Stabilisatoren, Farbstoffe und photochrome oder thermochrome Verbindungen.

Als Katalysatoren/Initiatoren bzw. Vernetzungsinitiator kommen alle geläufigen und dem Fachmann bekannten Starter/Startsysteme in Frage, einschließlich radikalischer Photostarter, radikalischer Thermostarter, kationischer Photostarter, kationischer Thermostarter und beliebiger Kombinationen derselben.

Unter bestimmten Umständen kann ganz auf den Vernetzungsinitiator verzichtet werden, wie z. B. gegebenenfalls im Fall von Elektronenstrahl- oder Laserhärtung.

Konkrete Beispiele für einsetzbare radikalische Photostarter sind Irgacure ® 184 (1-Hydroxycyclohexylphenylketon),Irgacure ® 500 (1-Hydroxycyclohexylphenylketon, Benzophenon) und andere von der Firma Ciba-Geigy erhältliche Photoinitiatoren vom Irgacure®-Typ, Darocure 1173, 1116, 1398, 1174 und 1020 (Fa. Merck), Benzophenon, 2-Chlorthioxanthon,2-Methylthioxanthon,2-Iso-propylthioxanthon, Benzoin, 4,4'-Dimethoxybenzoin, Benzoinethylether, Benzoinisopropylether, Benzildimethylketal, 1,1,1-Trichloracetophenon, Diethoxyacetophenon und Dibenzosuberon.

Beispiele für radikalische Thermostarter sind bevorzugt organische Peroxide in Form von Diacylperoxiden, Peroxydicarbonaten, Alkylperestern, Alkylperoxiden, Dialkylperoxiden, Perketalen, Ketonperoxiden und Alkylhydroperoxiden sowie Azo-Verbindungen. Als konkrete Beispiele wären hier insbesondere Dibenzoylperoxid, tert-Butylperbenzoat und Azobisisäbutyronitril zu nennen. Ein Beispiel für einen kationischen Photostarter ist Cyracure® UVI-6974, während ein bevorzugter kationischer Thermostarter 1-Methylimidazol ist.

Die Polykondensation induzierende Katalysatoren sind z. B. Brönsted-Säuren und -Basen, wie Mineralsäuren oder tertiäre Amine, für die anionische Polykondensation und Lewis-Säuren, wie Metallalkoholate (z. B. Aluminiumalkoholate im Falle von Epoxysilanen), für die kationische Polykondensation. Bei Beteiligung von Epoxidgruppen ist der Zusatz von Ringöffnungskatalysatoren wie beispielsweise N-Alkylimidazolen von besonderem Vorteil.

Gegebenenfalls kann die Zusammensetzung noch eines oder mehrere Lösungsmittel enthalten, bevorzugt organische Lösungsmittel, beispielsweise Alkohole, wie Ethanol, Isopropanol oder Butanol, Ketone wie Aceton, Ester wie Ethylacetat, Ether wie Tetrahydrofuran und aliphatische, aromatische und halogenierte Kohlenwasserstoffe, wie Hexan, Benzol, Toluol und Chloroform.

Der Lösungsmittelanteil der Zusammensetzung kann vor oder nach der Herstellung des Brechzahlgradienten variiert werden, beispielsweise durch Erwärmen. Bevorzugt ist ein Lösungsmittelanteil von 0 bis 30 Gew.-%.

In einer vorteilhaften Weiterbildung kann die Zusammensetzung noch ein Matrixmaterial enthalten. Dies ist insbesondere von Vorteil, wenn Monomere verwendet werden, welche nicht mit einem Oligomer oder Polymer modifiziert sind. Die zugegebene Matrix kann sowohl die Entstehung des Brechzahlgradienten, indem beispielsweise die Diffusion der Monomere beeinflusst wird, als auch, wie schon ausgeführt, den entstehenden Brechzahlgradienten beeinflussen. Darüberhinaus kann die Matrix zur Stabilisierung des Brechzahlgradienten beitragen. Bevorzugt werden Matrixmaterialien, die in der Zusammensetzung löslich sind.

Die Menge an Matrixmaterial ist nicht kritisch und kann zwischen 0,1 bis 98 Gew.-% liegen.

Das Matrixmaterial kann ein polymerisierbares oder polykondensierbares organisches Monomer, Oligomer und / oder Prepolymer, ein organisches Polymer und / oder ein Kondensat aus einer oder mehreren hydrolysierbaren, gegebenenfalls organisch modifizierten anorganischen Verbindungen umfassen. Das Matrixmaterial umfasst bevorzugt mindestens ein organisches Polymer.

Bei den organischen Polymeren, die im Matrixmaterial enthalten sein können, kann es sich um beliebige bekannte Kunststoffe handeln. Bevorzugt sind Polymere, die sich in den oben genannten Lösungsmitteln oder Gemischen davon lösen, z.B. Polyacrylsäure, Polymethacrylsäure, Polyacrylate, Polymethacrylate, Polyethylenglykole, Polyolefine, Polystyrol, Polyamide, Polyimide, Polyvinyl-Verbindungen wie Polyvinylchlorid, Polyvinylalkohol, Polyvinylbutyral, Polyvinylacetat, Polyvinylpyrrolidon, Paravinylguajacol und entsprechende Copolymere, z.B. Poly-(ethylenvinylacetat), Polyester, z.B. Polyethylenterephthalat oder Polydiallylphthalat, Polyarylate, Polycarbonate, Polyether, z.B. Polyoxymethylen, Polyethylenoxid und Polyphenylenoxid, Polyetherketone, Polysulfone, Polyepoxide, Fluorpolymere, z. B. Polytetrafluorethylen, und Organopolysiloxane. Vorzugsweise handelt es sich um transparente Polymere.

In einer vorteilhaften Weiterbildung kann die Zusammensetzung auch die eine, vorzugsweise transparente, härtbare Matrix enthalten.

Unter Härtung versteht man in diesem Fall Polymerisationen, Polykondensationen und / oder Polyadditionen, welche zu einer Verfestigung der Matrix führen.

Die Menge an härtbarer Matrix ist nicht kritisch und kann zwischen 0,1 bis 98 Gew.-% liegen. Dies betrifft insbesondere in vorteilhafter Weise den Aspekt, wenn die Stabilisierung des Brechzahlgradienten gefordert ist. Die härtbare Matrix beeinflusst die Entstehung des Brechzahlgradienten, indem beispielsweise die Diffusion der Monomere verändert wird. Darüber hinaus kann auch, wie schon ausgeführt, der Brechzahlunterschied zwischen Matrix und den polymerisierten oder polykondensierten Monomeren zur Ausbildung des Brechzahlgradienten genutzt werden. Die Härtung der Matrix kann sowohl vor, während, als auch nach der Erzeugung der Potentialdifferenz durchgeführt werden, bevorzugt vor der Erzeugung der Potentialdifferrenz.

Bevorzugt werden Matrixmaterialien, bzw. Vorläufer der härtbaren Matrix verwendet, die in der Zusammensetzung löslich sind.

Bei der härtbaren Matrix kann es sich beispielsweise um die üblichen organischen Bindemittelsysteme für Lacke und Harze handeln. Die Härtung der Matrix kann physikalisch oder bevorzugt chemisch erfolgen. Es kann sich um oxidativ härtende, kalthärtende oder um thermisch oder durch Bestrahlung härtende Harze handeln. Es kann sich um Ein- oder Zweikomponentenlacke handeln. Bevorzugt handelt es sich um chemisch härtende oder vernetzbare Bindemittelsysteme. Solche härtbaren Bindemittelsysteme sind dem Fachmann geläufig.

Bei den einsetzbaren Bindemittelsystemen oder Lacken bzw. den dafür verwendeten Polymeren oder Oligomeren oder Vorstufen davon handelt es sich z. B. um die üblichen, aus dem Stand der Technik bekannten Bindemittelsysteme. Insbesondere handelt es sich um organische Polymere, Oligomere oder Vorstufen davon. Unter den Vorstufen der Polymere oder Oligomere werden die Monomere oder daraus gebildete niedermolekulare Polymerisations-, Kondensations- oder Additionsprodukte verstanden, von denen die Polymere oder Oligomere abgeleitet sind.

Beispiele für Bindemittelsysteme oder Lacke bzw. die dafür verwendeten organische Polymere oder Oligomere sind Epoxidharz-Lacke, wie Bisphenol-A-Harze, Bisphenol-F-Harze, aliphatische und heterocyclische Epoxidharze oder thermoplastische Epoxidlackharze; Öllacke, die Öle, wie z.B. Leinöl, Holzöl oder Sojaöl enthalten, die gegebenenfalls mit Polybutadienölen modifiziert sind; Nitrocellulose-Lacke, die Nitrocellulosen enthalten; Lacke aus Celluloseester organischer Säuren, wie Ester der Cellulose mit Essigsäure oder Buttersäure oder die Anhydride davon, wobei z.B. Celluloseacetobutyrate auch in Polyurethanlacken Verwendung finden; Chlorkautschuk-Lacke, die z.B. chloriertes Polyisopren, Polypropylen oder Polyethylen enthalten; Lacke aus Polyvinylverbindungen bzw. Polyvinylharzen, wie Polyolefine, z.B. Polyethylen, Ethylen-Vinylacetat-Copolymere und Ethylen-Maleinsäure-(anhydrid)-Copolymere, PVC, Polyvinylidenchlorid, Polyvinylalkohol, Polyvinylacetale, z.B. Polyvinylbutyral, Polyvinylether, z.B. Methyl- oder Ethylether, Polyvinylester, z.B. Polyvinylacetat (PVA) und Polyethylenterephthalat, Polyvinylpyrrolidon, Polystyrol, Styrol-Acrylnitril-Copolymere (SAN), Acryinitril-Butadien-Styrol-Copolymere (ABS), Styrol-Maleinsäureester-Copolymere, Styrol-Butadien-Copolymere und Styrol-Maleinsäureanhydrid-Copolymere; Lacke auf Basis von Acrylharzen, wie Polyacrylsäure, Polymethacrylsäure, Polyacrylamid, Acrylester oder Methacrylester, z.B. Polymethyl(meth)acrylat; Alkydharze, die zweibasische Säuren oder Anhydride, wie Phthalsäure und Phtalsäureanhydrid, und Polyole oder Kondensationsproduke davon enthalten, die öl- oder fettsäuremodifiziert sind; gesättigte Polyesterharz-Lacke, die gesättigte Polyester aus gesättigten Monomeren mit zwei oder mehr funktionellen Gruppen (OH- und / oder COOH-Gruppen) enthalten; Polyurethan-Lacke, die häufig als Zweikomponentensysteme verwendet werden, die blockierte oder unblockierte Polyisocyanate und Polyhydroxylverbindungen enthalten; Siliconharz-Lacke; Harnstoff-, Melamin- und Phenolharz-Lacke; sowie Polyarylate, Polyamide, Polyether, Polyimide und Polycarbonate. Es können auch Kombinationen dieser Lacke bzw. dieser Polymere verwendet werden. Es können immer auch die Vorstufen, wie z.B. die Monomere der genannten Polymere oder Oligomere, eingesetzt werden.

Bevorzugte Bindemittelsysteme sind Polyurethanharz-Lacke und Polyepoxidharz-Lacke. Das Bindemittelsystem umfasst auch die gegebenenfalls eingesetzten Härter oder Vernetzer.

Bevorzugt handelt es sich um ein Bindemittelsystem, welches nicht mit den eingesetzten Monomeren reagiert und somit unabhängig von Polymerisation des Photopolymers reagiert.

Bevorzugt eingesetzte organische Polymere oder Oligomere oder Vorstufen davon, wie Monomere, sind Polyepoxide, Polyole, unblockierte oder insbesondere blockierte Polyisocyanate, Polyester, Polyamine, Polycarbonsäuren oder Polycarbonsäureanhydride, die jeweils zwei oder mehr funktionelle Gruppen enthalten. Hier bezieht sich der Ausdruck "Poly" auf die funktionelle Gruppe und nicht auf den Polymerisationsgrad. Dementsprechend besitzen die Polyole zwei oder mehr Hydroxygruppen und es kann sich um ein Monomer, Oligomer oder Polymer (z.B. ein Polyurethan) handeln. Konkrete Komponenten werden im Folgenden an bevorzugten Bindemittelsystemen beispielhaft veranschaulicht.

Es können dem Fachmann bekannte Bindemittelsystem auf Epoxidbasis eingesetzt werden. Beispiele für Polyepoxide sind Bisphenol-A-Harze (z.B. Kondensationsprodukte aus Bisphenol A und Epichlorhydrin), Bisphenol-F-Harze (z.B. Kondensationsprodukte aus Bisphenol F und Epichlorhydrin), aliphatische Epoxidharze (z.B. niedrig viskose Glycidylether), cycloaliphatische Epoxidharze und heterocyclische Epoxidharze (z.B. Triglycidylisocyanurat) oder thermoplastische Epoxidharz-Lacke. Solche Systeme beinhalten auch die Verwendung von "expanding monomers" (z. B. Spiroorthocarbonate oder Spiroorthoester), welche auch erst in situ gebildet werden können. Häufig werden Polyepoxidharze für die Filmbildung mit Härtern versetzt, um eine Vernetzung zu erzielen. Als Härter kommen organische oder anorganische Verbindungen mit reaktionsfähigem Wasserstoff in Betracht, die mit Epoxid- oder Hydroxylgruppen reagieren können. Beispiele für eingesetzte Härter sind Polyamine (z. B. Diamine, wie Ethylendiamin, Cyclohexaminderivate), Polyaminoamidharze, Polyisocyanate, hydroxylhaltige Kunstharze, wie Harnstoff-, Melamin- und Phenolharze, Fettsäuren und organische Säuren mit reaktionsfähigen Doppelbindungen, wie Acrylsäure oder Methacrylsäure. Bei Einsatz der letztgenannten Härter kann die Vernetzung auch durch Elektronenstrahlung erfolgen.

Polyisocyanate werden z.B. für Polyurethanharze verwendet. Das Polyisocyanat kann zwei oder mehr Isocyanatgruppen aufweisen. Es kann z.B. aliphatisch, alicyclisch, aromatisch oder heterocyclisch, monocyclisch oder polycyclisch sein.

Es können übliche Polyisocyanate verwendet werden, z.B. monomere Polyisocyanate, Polyisocyanat-Addukte, sogenannte modifizierte Polyisocyanate oder Mischungen davon. Diese sind dem Fachmann bekannt und im Handel erhältlich.

Bei den Polyisocyanat-Addukten handelt es sich z.B. um solche, die üblicherweise als Härter für zweikomponentige Urethanlacke Verwendung finden.

Beispiele für geeignete Polyisocyanate sind die aus der Polyurethanchemie bekannten Diisocyanate, wie z.B. 1,3-Diisocyanatobenzol, 2,4 und 2,6-Toluylendiisocyanat (TDI), 1, 6-Hexamethylendiisocyanat (HMDI), 4,4'- und 2,4-Diphenylmethandiisocyanat (MDI), Naphthylendiisocyanat, Xylylendiisocyanat, Isophorondiisocyanat, Paraphenyldiisocyanat, Dicyclohexylmethandiisocyanat, Cyclohexyidiisocyanat, Polymethylpolyphenylisocyanat, 1,6-Dodecamethylendiisocyanat, 1,4-Bis (isocyanatocyclohexyl) methan, Pentamethylendiisocyanat, Trimethylendiisocyanat, Triphenylmethandiisocyanat, sowie die aus diesen Diisocyanaten abgeleiteten höhermolekulare Polyisocyanate z.B. auf Isocyanurat-, Uretdion-, Allophanat- und Biuretbasis.

Die Isocyanate sind z.B. unter den Handelsbezeichnungen Desmodur und Baymidur (von Bayer), CARADATE (von Shell), TEDIMONX (von Enichem) und LUPRANAT (von BASF) erhältlich. Beispiele für monomere Polyisocyanate mit mehr als zwei Isocyanatgruppen sind z. B. 4-lsocyanatomethyl-1,8-octandiisocyanat und aromatische Polyisocyanate wie 4,4',4"-Triphenylmethantriisocyanat oder Polyphenylpolymethylenpolyisocyanate.

Das Polyisocyanat kann in blockierter Form verwendet werden, um zu verhindern, dass eine unkontrolliert schnelle Reaktion einsetzt, und erst nach Entblockierung, z.B. durch Erwärmen, reaktiv werden. Die Blockierung von Isocyanaten ist ein dem Fachmann bekanntes Verfahren zur reversiblen Herabsetzung der Reaktivität von Isocyanaten. Zur Blockierung der Isocyanate kommen alle gängigen Blockierungsmittel in Betracht, wie z.B. Acetonoxim, Cyclohexanonoxim, Methylethylketoxim, Acetophenonoxim, Benzophenonoxim, 3,5-Dimethylpyrazol, 1,2,4-Triazol, Malonsäureethylester, Acetessigsäureethylester, s-Caprolactam, Phenol oder Ethanol.

Als Polyolkomponente können reine Di-, Tri- oder Polyalkohole, wie z.B. Ethylenglycol, Trimethylolpropan, oder partiell verseifte Fettsäureglyceride verwendet werden. Diese werden aber gewöhnlich nur als Ausgangsbasis für höhermolekulare Polyhydroxylverbindungen verwendet. Hierbei kann es sich z.B. um mit Dicarbonsäuren entstehende, mehr oder weniger verzweigte Polyesterpolyole (Desmophen ®- Typen) oder durch Anlagerung von Epoxiden entstehende Polyetherpolyole (Desmophen ® U-Typen) handeln. Andere Beispiele sind hydroxyfunktionelle Acrylharze (Desmophen A-Typen).

Aus den Polyisocyanaten und den Polyolen können Polyurethanharz-Lacke gebildet werden. Natürlich kann es vor allem bei unblockierten Polyisocyanaten erforderlich sein, die Komponenten erst kurz vor Gebrauch miteinander zu mischen. Polyisocyanate können auch mit Verbindungen mit anderen funktionellen Gruppen, die aktiven Wasserstoff enthalten, umgesetzt werden. Beispiele für diese Gruppen sind Thiolgruppen (-SH), primäre oder sekundäre Aminogruppen (-NHR', worin R' z.B. H, Alkyl, Cycloalkyl, Aryl und entsprechende Aralkyl- und Alkarylgruppen sein kann) oder Carboxylgruppen (-COOH). Als Reaktionsprodukte bilden sich bei der Umsetzung mit Isocyanaten Urethane (bei Hydroxyl und Carboxyl), Thiourethane (bei Thiol) oder Harnstoffe (bei Amin).

Polyamide sind Kondensationsprodukte von Diaminen und Dicarbonsäuren oder deren Derivaten, wobei aliphatische und/oder aromatische Verbindungen eingesetzt werden können. Polyamide mit aromatischen Einheiten sind insbesondere bezüglich der Temperaturstabilität interessant. Auch Polyimide, z. B. Polykondensate aus aromatschen Diaminen, wie Benzidin, 4,4-Diaminodiphenylether oder 4,4'-Bis(3-amino-phenoxy)diphenylsulfon, und aromatischen Tetracarbonsäuren oder deren Derivaten, wie 4,4'-Benzophenontetracarbonsäuredianhydrid oder Pyromellitsäuredianhydrid, und Polybenzimidazole, die Kondensationsprodukte aus aromatischen Tetraminen und Dicarbonsäuren oder deren Derivaten darstellen, zeichnen sich durch hohe Wärmebeständigkeit aus. In der erfindungsgemäßen Zusammensetzung können für die genannten Kunststoffe die entsprechenden Monomere oder niedermolekulare Kondensationsprodukte eingesetzt werden.

Die vorstehend genannten Bindemittelsysteme eignen sich insbesondere für Beschichtungszusammensetzungen. Sie sind aber auch als Bindemittelsysteme für Formmassen zur Herstellung von Formkörpern geeignet, wobei Formkörper auch Folien beinhaltet. Epoxidharze oder Polyurethanharze sind z.B. auch zur Herstellung von Formkörpern gut geeignet.

Gerade bei der Verwendung von Epoxid-Harzen ist praktisch keine Schrumpfung durch die Polymerisation des Monomers mehr zu beobachten. Bei der Verwendung von selbsthärtenden Harzen ist auch keine Belichtung zur Härtung der Matrix nötig.

Die Härtung kann aber auch mit der Abreaktion von bei der Bildung der Gradientenstruktur nicht umgesetzter Monomere verbunden werden.

In einer vorteilhaften Weiterbildung kann als härtbares Matrixmaterial auch ein organisch modifiziertes anorganisches Kondensat aus polymerisierbaren oder polykondensierbaren Monomeren und / oder hydrolysierbaren Silanen, welche auch polymerisierbare und / oder polykondensierbare Gruppen aufweisen können, verwendet werden. Solche Zusammensetzungen sind bspw. aus WO 03/058292 bekannt, auf die hiermit explizit Bezug genommen wird.

Zusätzlich ist die erfindungsgemäße Ausbilung von Gradientenstrukturen auch auf Kompositmaterialien übertragbar. Dazu können der Erfindung nanoskalige Teilchen zugegeben werden, welche gegebenenfalls oberflächenmodifiziert sein können. Abhängig vom Material der nanoskaligen Teilchen können diese zu einer Erhöhung oder einer Erniedrigung der Brechzahl führen. Die Nanopartikel können dabei ebenfalls mit polymerisierbare oder polykondensierbare Oberflächengruppen aufweisen. Das erfindungsgemäße Verfahren führt auch für diese Kompositmaterialien zu deutlichen Verbesserungen. Die Herstellung und Oberflächenmodifizierung der nanoskaligen Teilchen sind aus WO 03/058292 bekannt, auf die hiermit explizit Bezug genommen wird. Abhängig von der Art der Ausführung können die nanoskaligen Teilchen dabei als diffundierende Komponente, d.h. analog zu den Monomeren, oder auch als Bestandteil der Matrix verwendet werden.

Desweiteren betrifft die Erfindung auch ein optisches Element mit Gradientenstruktur, wobei die Gradientenstruktur durch einen Brechzahlgradienten gebildet wird, enthaltend folgende Komponenten:
(a) 4,9 bis 98 Gew.-% eines oder mehrerer organischer Polymere,
(b) 0,1 bis 50 Gew.-% mindestens einer ionischen Flüssigkeit,
(c) 0 bis 5 Gew.-% eines oder mehrerer Additive ausgewählt aus thermischen oder photochemischen Vernetzungsinitiatoren, Sensibilisierungsmitteln, Netzhilfsmitteln, Haftvermittlern, Verlaufsmitteln, Antioxidationsmitteln, Stabilisatoren, Farbstoffen, photochromen oder thermochromen Verbindungen

In einer vorteilhaften Weiterbildung der Erfindung sind das oder die Polymere ausgewählt aus der Gruppe enthaltend Poly(meth)acrylsäure und Derivate, Poly(meth)acrylate, Poly(meth)acrylnitrile, Polystyrole oder Polystyrol-Derivate, Polyalkene, halogenierte Polyalkene, Polyvinylacetat, Polyvinylpyrrolidon, Polyvinylcarbazol, Poly(polyethylenglycol)(meth)-acrylate, Poly(polyethylenglycol)di(meth)acrylate.

Der Gehalt an mindestens einer ionischen Flüssigkeit liegt mit Vorteil zwischen 1 bis 50 Gew.-%, bevorzugt zwischen 15 und 50 Gew.-%, besonders bevorzugt zwischen 20 und 40 Gew.-%, ganz besonders bevorzugt zwischen 20 und 30 Gew.-%.

In einer weiteren vorteilhaften Weiterbildung enthält das optische Element zusätzlich 0,1 bis 98 Gew.-% eines oder mehrerer organischer Polymere ausgewählt aus der Gruppe enthaltend Polyacrylate, Polymethacrylate, Polyepoxide, Polyvinyle, Polyethylene, oder Polyethylenglycole.

In einer weiteren vorteilhaften Weiterbildung enthält das optische Element zusätzlich 0,1 bis 98 Gew.-% einer gehärteten Matrix aus Polymeren und / oder aus Kondensat aus hydrolysierbaren Silanen, welche auch polymerisierbare und / oder polykondensierbare Gruppen aufweisen können. Beispiele für solche Kondensate finden sich in WO 03/058292, auf die hiermit explizit Bezug genommen wird.

Im Falle von Polymeren sind Polyurethanharz-Lacke und Polyepoxidharz-Lacke bevorzugt.

In eine weiteren Vorteilhaften Weiterbildung enthält das optische Element zusätzlich noch nanoskalige Teilchen, welche gegebenenfalls oberflächenmodifizierte oberflächenmodifiziert sind. Beispiele für geeignete Teilchen, welche gegebenenfalls oberflächenmodifiziert sind, finden sich in WO 03/058292, auf die hiermit explizit Bezug genommen wird.

Die Komponenten zur Herstellung der Zusammensetzung bzw. einer Vorstufe davon können in beliebiger Weise und Reihenfolge miteinander gemischt werden.

Für die Beschichtung werden vorzugsweise für optische Anwendungen geeignete Substrate ausgewählt, wie beispielsweise Glas, Keramik, Silicium, Metall, Halbleiter-Materialien oder (vorzugsweise transparente) Kunststoffe, wie PET, PE und PP. Ein besonders bevorzugtes Substrat ist eine Kunststofffolie. Die Beschichtung kann nach üblichen Methoden erfolgen, z. B. durch Tauchen, Fluten, Rakeln, Gießen, Schleudern, Spritzen, Aufstreichen, Slot-Coating, Meniskus-Coating, Foliengießen, Spinnen oder Sprühen. Hierfür eignen sich natürlich flüssige Vorstufen der Zusammensetzung, wobei die erforderliche Viskosität beispielsweise durch Zugabe oder Entfernen von Lösungsmittel(n) eingestellt werden kann. Alternativ kann die Wahl der ionischen Flüssigkeit oder der gegebenenfalls verwendeten härtbaren Matrix die Viskosität beeinflussen. Bevorzugte Schichtdicken (der fertigen Beschichtung) liegen bei 0,2 bis 300 µm, besonders bevorzugt zwischen 0,2 bis 100 µm.

In dieser Form kann das Folienmaterial aufgewickelt, lichtgeschützt und klimatisiert (15 bis 30 °C) zwischengelagert werden. Auf diese Weise kann auch ein Folienverbund bzw. -komposit hergestellt werden. Folien mit einer Beschichtung, die einen Brechzahlgradienten aufweist, auf die gegebenenfalls eine zweite Folie auflaminiert wurde (Folienkomposit) sind bevorzugte erfindungsgemäße optische Elemente.

Anschließend wird in der Zusammensetzung auf die oben beschriebene Weise eine Potentialdifferenz erzeugt, so dass durch gerichtete Diffusion und der induzierten lokalen Polymerisation oder Polykondensation ein Brechzahlgradienten gebildet wird. Die Potentialdifferenz wird bevorzugt durch ein Belichtungsverfahren erzeugt.

Die sich bei Erzeugung einer Potentialdifferenz abspielenden Vorgänge werden nachstehend für eine bevorzugte Ausführungsform erläutert.

Durch eine lokale Belichtung polymerisieren die Monomere der Zusammensetzung zu Polymeren. Dabei können sowohl lineare, wie auch verzweigte Polymere entstehen. Dadurch wird ein chemischer Potentialgradient für noch nicht polymerisierte Monomere zu der unbelichteten Nachbarregion gebildet. Aus dieser Nachbarregion diffundieren daher weitere Monomere in die belichtete Region. Dieser Prozess kann während und nach der Belichtung erfolgen und dauert zwischen wenigen Sekunden bis wenige Minuten, je nach Belichtungsbedingungen und Temperatur. Durch den Brechzahlunterschied zwischen den verschiedenen Bereichen mit unterschiedlicher Polymerisation entsteht auf diese Weise ein lokaler Brechzahlgradient.

Die gegebenenfalls zugegebenen Vorläufer der härtbaren Matrix können sowohl vor dem Anlegen der Potentialdifferenz, während, als auch nach dem Anlegen der Potentialdifferenz gehärtet werden, bevorzugt nach dem Anlegen der Potentialdifferenz.

Gegebenenfalls können auch die ionischen Flüssigkeiten und /oder die nicht abreagierten Monomere nach der Ausbildung des Brechzahlgradienten entfernt werden, beispielsweise durch Auswaschen. Dadurch ist es möglich mit diesen Systemen auch optischen Reliefstrukturen zu erzeugen. Diese können auch in Kombination mit Gradientenstrukturen erzeugt werden.

Zusammengefasst erlaubt das erfindungsgemäße Verfahren auf eine kostengünstige und effiziente Weise die Herstellung von Gradientenstrukturen, welche deutlich schärfere Brechzahlgradienten aufweisen. Dadurch kann beispielsweise bei gleicher Dicke des Materials eine wesentliche Verbesserung der optischen Eigenschaften erreicht werden. Die Produktion solcher Systeme wird auf diese Weise deutlich einfacher und kostengünstiger. Gleichzeitig ist auch eine große Variabilität beispielsweise bezüglich der verwendeten Monomere realisierbar, da die Eigenschaften der ionischen Flüssigkeit und / oder der Matrix sehr flexibel an die gewünschten Gegebenheiten angepasst werden können.

Das erfindungsgemäße Verfahren eignet sich insbesondere zur Herstellung von optischen Elementen mit einem Brechzahlgradienten. Die optischen Elemente sind insbesondere als holographische Anwendungen, Lichtmanagementfolien, Diffusoren, planare Gradientenindexlinsen in der abbildenden Optik, Head-up-Displays, Head-down-Displays, Lichtwellenleiter, vor allem in der optischen Nachrichten- und Übertragungstechnik, und optische Datenspeicher geeignet. Beispiele für herstellbare optische Elemente sind Sicherheitshologramme, Bildhologramme, digitale Hologramme zur Informationsspeicherung, Systeme mit Komponenten, die Lichtwellenfronten verarbeiten, planare Wellenleiter, Strahlteiler und Linsen.

In einer bevorzugten Ausführungsform der Erfindung zur Herstellung eines Transmissionshologramms wird ein mit einem Polymer modifiziertes (Meth)acrylat-Monomer mit einer ionischen Flüssigkeit (15 bis 50 Gew.-%) und einem Photoinitiator (0,02 bis 0,1 Gew.-%) versetzt und zu einer homogenen Mischung gerührt. Die erhaltene Zusammensetzung wird auf eine Glasoberfläche aufgetragen und mit einer zweiten Glasplatte bedeckt. Die Schichtdicke beträgt zwischen 0,5 und 5 µm. Mit Hilfe von Zwei-Wellenmischen eines Laserstrahls mit einer Wellenlänge zwischen 300 nm und 500 nm und einer Intensität zwischen 0,5 und 2 mW/m² werden phasenmodulierte Volumenhologramme sowohl als Transmissions- als auch als Reflexionshologramme erzeugt. Die Belichtungszeit beträgt zwischen 1 Sekunden und 10 Minuten, bevorzugt zwischen 1 und 10 Sekunden. Die erhaltenen Reflexions- oder Transmissionshologramme zeichnen sich bei gleicher Schichtdicke durch eine deutlich erhöhte Stabilität und einen deutlich schärferen Brechzahlgradienten aus. Darüber hinaus wird in einer deutlich kürzeren Belichtungszeit ein stabiles Hologramm erhalten.

In einer weiteren bevorzugten Ausführungsform der Erfindung zur Herstellung eines Diffusors wird ein mit einem Polymer modifiziertes (Meth)acrylat-Monomer mit einer ionischen Flüssigkeit (15 bis 50 Gew.-%, bevorzugt zwischen 20 bis 30 Gew.-%) und einem Photoinitiator (0,02 bis 0,1 Gew.-%) versetzt und zu einer homogenen Mischung gerührt. Die erhaltene Zusammensetzung wird auf eine gemusterte Maske mit einem zufälligen Transparent/Dunkel-Muster mit einer Körnung zwischen 1 µm und 20 µm aufgetragen und mit einer Kunststofffolie als Schutzfolie bedeckt. Der Folienkomposit wird geglättet und durch die Maske mit einer Lichtquelle, vorzugsweise einer UV-Lampe, mit einer Lichtintensität zwischen 40 mW/cm² und 100 mW/cm² belichtet. Die Belichtungszeit beträgt zwischen 10 Sekunden und 10 Minuten. Nach der Erzeugung des Brechzahlgradienten wird erneut belichtet, allerdings von der entgegengesetzten Seite, d.h. nicht durch die Maske, um nicht abreagierte Monomere des Photopolymers zu polymerisieren.

In einer weiteren bevorzugten Ausführungsform der Erfindung zur Herstellung eines Diffusors wird der oben angegebenen Zusammensetzung noch 5 bis 30 Gew.-% eines Bindemittelsystems, vorzugsweise eines Epoxidharzes und eines Vernetzers, zugegeben.

Auch in diesem Beispiel weisen die erhaltenen Diffusoren bei gleicher Schichtdicke eine deutlich verbesserte Winkelabhängigkeit der Transmission auf.

Weitere Einzelheiten und Merkmale ergeben sich aus der nachfolgenden Beschreibung von bevorzugten Ausführungsbeispielen in Verbindung mit den Unteransprüchen. Hierbei können die jeweiligen Merkmale für sich alleine oder zu mehreren in Kombination miteinander verwirklicht sein. Die Möglichkeiten, die Aufgabe zu lösen, sind nicht auf die Ausführungsbeispiele beschränkt.

So umfassen beispielsweise Bereichsangaben stets alle - nicht genannten - Zwischenwerte und alle denkbaren Teilintervalle.

### Herstellung eines Transmissionshologramms

### Referenzbeispiel 1

Poly(ethylenglycol)methacrylat (2,0 g) Monomer (Sigma-Aldrich Co.) und Initiator Irgacure 184 (0,1 g, Ciba Specialty Chemicals (Pty) Ltd) werden in einem Reaktionsgefäß bei Raumtemperatur für 5 Minuten mit einem Magnetrührer zu einer homogenen Zusammensetzung verrührt. Danach wird eine Glasoberfläche mit dem lichtempfindlichen Material beschichtet und die Beschichtung (Dicke 1,5 µm) mit einer zweiten Glasplatte bedeckt. Mittels Zwei-Wellenmischen werden phasenmodulierte Volumenhologramme als Transmissionshologramm erzeugt. Der Laserstrahl eines Argon-Ionenlasers mit einer Intensität zwischen 0,5 und 2 mW/m² und mit einer Wellenlänge von 351 nm wird auf einen Durchmesser von ungefähr 0,5 mm fokussiert und mit einem Strahlteiler in zwei Teilstrahlen gleicher Intensität geteilt. Die Interferenz dieser beiden Strahlen führt zu einer räumlich periodischen Änderung der Lichtintensität.

### Beispiel 2

Poly(ethylenglycol)methacrylat (2,0 g) Monomer (Sigma-Aldrich Co.), [BMIM]BF₄ (0,5 g), hergestellt nach Creary et al. 2005, und Initiator Irgacure 184 (0,1 g, Ciba Specialty Chemicals (Pty) Ltd) werden in einem Reaktionsgefäß bei Raumtemperatur für 5 Minuten mit einem Magnetrührer zu einer homogenen Zusammensetzung verrührt. Danach wird eine Glasoberfläche mit dem lichtempfindlichen Material beschichtet und die Beschichtung (Dicke 1,5 µm) mit einer zweiten Glasplatte bedeckt. Mittels Zwei-Wellenmischen werden phasenmodulierte Volumenhologramme als Transmissionshologramm erzeugt. Der Laserstrahl eines Argon-Ionenlasers mit einer Intensität zwischen 0,5 und 2 mW/m² und mit einer Wellenlänge von 351 nm wird auf einen Durchmesser von ungefähr 0,5 mm fokussiert und mit einem Strahlteiler in zwei Teilstrahlen gleicher Intensität geteilt. Die Interferenz dieser beiden Strahlen führt zu einer räumlich periodischen Änderung der Lichtintensität.

Die entstandene Gradientenstruktur wird mit einem He-Ne-Laser mit der Wellenlänge von 633 nm als Referenz vermessen. Das durch das Gitter erzeugte Licht wurde mit einem "Lock-in"-Verstärker M 850 gemessen. Das erzeugte Transmissionshologramm besitzt eine Brechzahlmodulation von 0.01 (633 nm).

### Herstellung von lichtverteilenden Photopolymer-Kompositfolien (Diffusoren)

### Beispiel 3

Poly(ethylenglycol)methacrylat (4,0 g) (Sigma-Aldrich Co.), [BMIM]BF₄ (1,0 g), hergestellt wie in Beispiel 1, und Photoinitiator Irgacure 184 (0,2 g, Ciba Specialty Chemicals (Pty) Ltd), werden bei Raumtemperatur für 5 Minuten mit einem Magnetrührer zu einer homogenen Zusammensetzung verrührt. Danach wird die Zusammensetzung auf eine Maske mit einem zufälligen transparent/dunkel-Muster mit einem Maßstab von wenigen Mikrometern aufgetragen (Dicke 75 µm) und mit einer PET-Folie (Dicke 75 µm) als Schutzfolie bedeckt. Die Dicke der Schicht wurde durch eine als Begrenzung der Beschichtungsfläche auf der Maske gebrachten PET Folie mit einer Stärke von 75 µm bestimmt. Die Kompositfolie wird mit einer Rolle geglättet und durch die Maske mit einer Lichtquelle (Oriel UV Lampe, 1000 W, 58 mW/cm²) für 30 Sekunden belichtet. Danach wird erneut für 30 Sekunden mit der gleichen Lichtquelle belichtet, allerdings von der entgegengesetzten Seite, d.h. nicht durch die Maske. Man erhält einen Diffusor mit exzellenten Diffusionseigenschaften und hoher Transmission.

### Beispiel 4

Poly(ethylenglycol)methacrylat (4,0 g) (Sigma-Aldrich Co.), [BMIM]BF₄ (2,0 g), hergestellt wie in Beispiel 1, Epoxidharz (0,8 g Epoxyl L20, R&G Faserverbundwerkstoffe GmbH), Vernetzer (0,2 g, VE 3261, R&G Faserverbundwerkstoffe GmbH, 3-Aminomethyl-3,5,5-trimethylcyclohexylamin) und Photoinitiator Irgacure 184 (0.1 g, Ciba Specialty Chemicals (Pty) Ltd), werden bei Raumtemperatur für 28 Stunden mit einem Magnetrührer zu einer homogenen Zusammensetzung verrührt. Danach wird die Zusammensetzung auf eine Maske mit einem zufälligen transparent/dunkel-Muster mit einem Maßstab von wenigen Mikrometern aufgetragen (Dicke 75 µm) und mit einer PET-Folie (Dicke 75 pm) als Schutzfolie bedeckt. Die Dicke der Schicht wurde durch eine als Begrenzung der Beschichtungsfläche auf der Maske gebrachten PET Folie mit einer Stärke von 75 µm bestimmt. Die Kompositfolie wird geglättet und durch die Maske mit einer Lichtquelle (Oriel UV Lampe, 1000 W, 58 mW/cm²) für 30 Sekunden belichtet. Danach wird erneut für 30 Sekunden mit der gleichen Lichtquelle belichtet, allerdings von der entgegengesetzten Seite, d.h. nicht durch die Maske. Man erhält einen Diffusor mit exzellenten Diffusionseigenschaften und hoher Transmission.

### Beispiel 5

Triethyleneglycoldimethacrylat (3,4 g) (Sigma-Aldrich Co.), [BMIM]BF₄ (1,0 g), hergestellt wie in Beispiel 1, Epoxidharz (0,4 g Epoxyl L20, R&G Faserverbundwerkstoffe GmbH, Bisphenol-A-Epichlorhydrinharz und Bisphenol-F-Epichlorhydrinharz), Vernetzer (0,1 g, VE 3261, R&G Faserverbundwerkstoffe GmbH) und Photoinitiator Irgacure 184 (0.1 g, Ciba Specialty Chemicals (Pty) Ltd), werden bei Raumtemperatur für 28 Stunden mit einem Magnetrührer zu einer homogenen Zusammensetzung verrührt. Danach wird die Zusammensetzung auf eine Maske mit einem zufälligen transparent/dunkel-Muster mit einem Maßstab von wenigen Mikrometern aufgetragen (Dicke 75 µm) und mit einer PET-Folie (Dicke 75 µm) als Schutzfolie bedeckt. Die Dicke der Schicht wurde durch eine als Begrenzung der Beschichtungsfläche auf der Maske gebrachten PET Folie mit einer Stärke von 75 µm bestimmt. Die Kompositfolie wird geglättet und durch die Maske mit einer Lichtquelle (Oriel UV Lampe, 1000 W, 58 mW/cm²) für 30 Sekunden belichtet. Danach wird erneut für 30 Sekunden mit der gleichen Lichtquelle belichtet, allerdings von der entgegengesetzten Seite, d.h. nicht durch die Maske. Man erhält einen Diffusor mit exzellenten Diffusionseigenschaften und hoher Transmission.

### Referenzbeispiel 6

Poly(ethylenglycol)methacrylat (3,5 g) (Sigma-Aldrich Co.), und Photoinitiator Irgacure 184 (0.1 g, Ciba Specialty Chemicals (Pty) Ltd), werden bei Raumtemperatur für 5 Minuten mit einem Magnetrührer zu einer homogenen Zusammensetzung verrührt. Danach wird die Zusammensetzung auf eine Maske mit einem zufälligen transparent/dunkel-Muster mit einem Maßstab von wenigen Mikrometern aufgetragen (Dicke 75 µm) und mit einer PET-Folie (Dicke 75 µm) als Schutzfolie bedeckt. Die Dicke der Schicht wurde durch eine als Begrenzung der Beschichtungsfläche auf der Maske gebrachten PET Folie mit einer Stärke von 75 µm bestimmt. Die Kompositfolie wird geglättet und durch die Maske mit einer Lichtquelle (Oriel UV Lampe, 1000 W, 58 mW/cm²) für 30 Sekunden belichtet. Danach wird erneut für 30 Sekunden mit der gleichen Lichtquelle belichtet, allerdings von der entgegengesetzten Seite, d.h. nicht durch die Maske. Man erhält einen Diffusor als Referenzbeispiel.

### Referenzbeispiel 7

Poly-(ethylenglycol)methacrylat (3,4 g) (Sigma-Aldrich Co.), Epoxidharz (0,4 g Epoxyl L20, R&G Faserverbundwerkstoffe GmbH), Vernetzer (0,1 g, VE 3261, R&G Faserverbundwerkstoffe GmbH) und Photoinitiator Irgacure 184 (0.1 g, Ciba Specialty Chemicals (Pty) Ltd), werden bei Raumtemperatur für 24 Stunden mit einem Magnetrührer zu einer homogenen Zusammensetzung verrührt. Danach wird die Zusammensetzung auf eine Maske mit einem zufälligen transparent/dunkel-Muster mit einem Maßstab von wenigen Mikrometern aufgetragen (Dicke 75 µm) und mit einer PET-Folie (Dicke 75 µm) als Schutzfolie bedeckt. Die Dicke der Schicht wurde durch eine als Begrenzung der Beschichtungsfläche auf der Maske gebrachten PET Folie mit einer Stärke von 75 µm bestimmt. Die Kompositfolie wird geglättet und durch die Maske mit einer Lichtquelle (Oriel UV Lampe, 1000 W, 58 mW/cm²) für 30 Sekunden belichtet. Danach wird erneut für 30 Sekunden mit der gleichen Lichtquelle belichtet, allerdings von der entgegengesetzten Seite, d.h. nicht durch die Maske. Man erhält einen Diffusor als Referenzbeispiel.

Kurzbeschreibung der Figuren
- Fig. 1: Intensität des Transmissionshologramms aus Referenzbeispiel 1 nach verschiedenen Belichtungszeiten;
- Fig. 2: Intensität des Transmissionshologramms aus Beispiel 2 nach verschiedenen Belichtungszeiten;
- Fig. 3: Lichtmikroskopische Aufnahme der in Beispiel 2 hergestellten Gradientenstruktur;
- Fig. 4: Optische Profile der hergestellten Diffusoren.

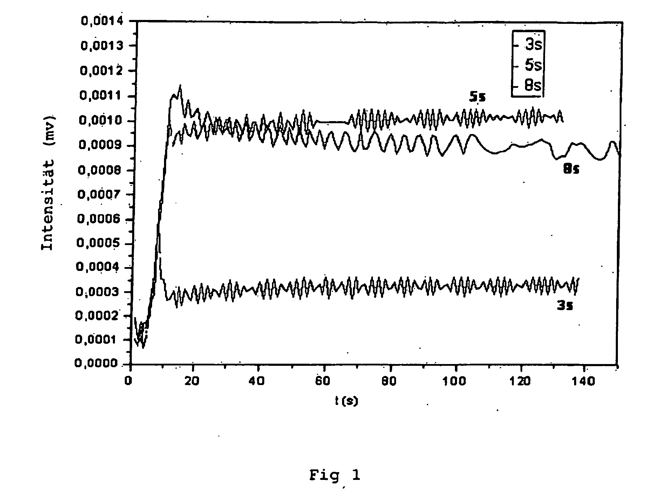

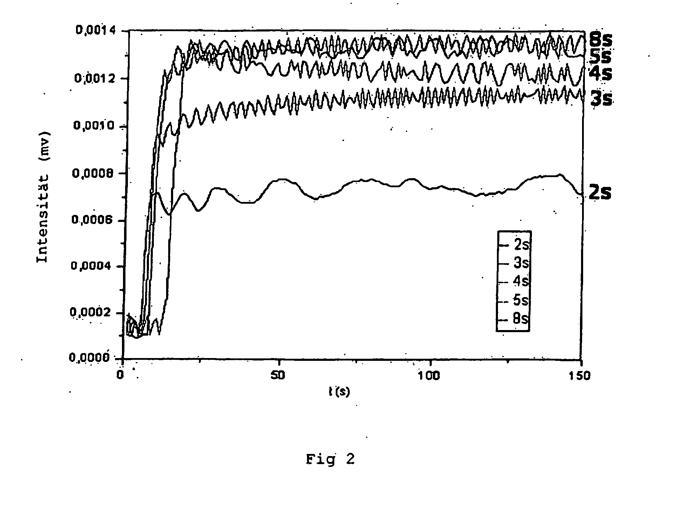

Figur 1 und Figur 2 zeigen die gemessene Intensität des Referenzstrahls bei 633 nm des Transmissionshologramms aus Referenzbeispiel 1 und Beispiel 2 nach unterschiedlich langen Belichtungszeiten. Die Belichtungszeit wurde mit Hilfe eines elektronischen Verschlusses kontrolliert.

Im Unterschied zur Zusammensetzung ohne die ionischen Flüssigkeit ist die Qualität des entstehenden Gitters deutlich verbessert. Es bildet sich nicht nur in kürzerer Zeit aus, sondern ist auch noch regelmäßiger und stabiler.

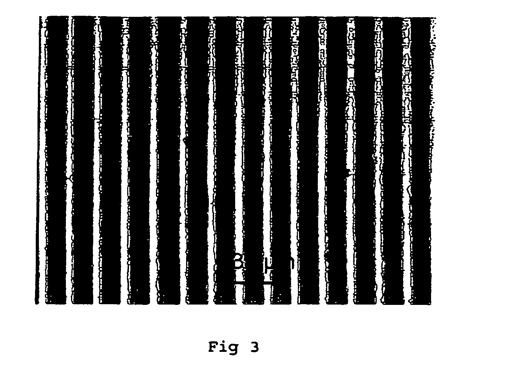

Figur 3 zeigt eine vergrößerte Aufnahme des Beugungsgitters aus Beispiel 2 aufgenommen mit einem optischen Mikroskop.

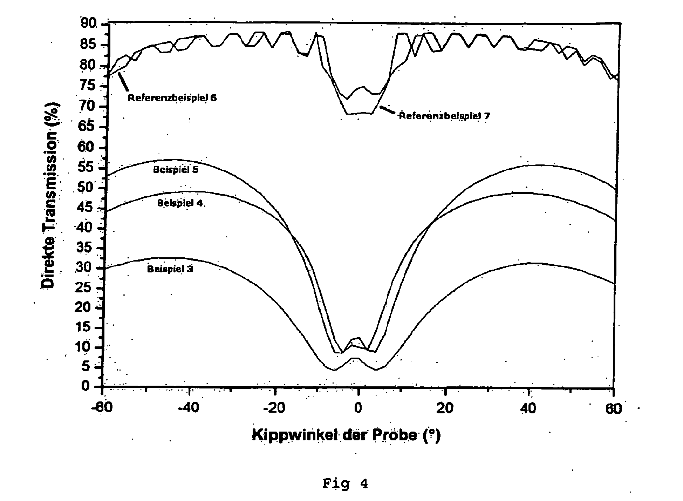

Figur 4 zeigt eine Messung der Winkelabhängigkeit der direkten Transmission der Diffusor mit polychromatischem Licht der Beispiele 3-5 und der Referenzbeispiele 6 und 7. Die durch das erfindungsgemäße Verfahren erreichte Verbesserung der optischen Eigenschaften ist deutlich zu erkennen.

### Liste der zitierten Literatur:

US 5,552,261
   US 5,529,473
   US 3,658,526
   US 4,959,284
   US 4,942,112
   US 5,013,632
   US 5,098,803
   US 6,482,551
   US 5,453,340
   US 2003/0157414
   US 2005/0231773
   US 7,022,392
   US 6,969,578
   US 6,268,089
   US 7,163,769
   US 2005/0101698
   WO 03/058292
"Ionic Liquids in Synthesis", P. Wasserscheid, T. Welton, Eds., Wiley-VCH, Weiheim, 2003.
P. Kubisa, J. Polym. Sci. Part A Polym. Chem. 2005, 43, 4675-4683.
N. Winterton, J. Mater. Chem., 2006, 16, 4281-4293
K. Hong, H. Zhang, J. M. Mays, A. E, Visser, C. S. Brazel, J. H. Holbrey, W. M. Reichert, R. D. Rogers, Chem. Commun., 2002, 1368-1369.
H. Zhang, K. Hong, J. W. Mays, Macromolecules, 2002, 35, 5738-5741.
V. Strehmel, A. Laschewsky, H. Wetzel, E. Görnitz, Macromolecules, 2006, 39, 923-930.
H. Kogelnik, "Coupled wave theory for thick hologram gratings", Bell Syst. Tech. J., 1969, 48, 2909-2947.
X. Creary, E. D. Wilis, Organic Synthesis, 2005, 82, 166.

## Patentansprüche

1. Verfahren zur Herstellung optischer Elemente mit Gradientenstruktur, insbesondere für holographische Anwendungen, wobei die Gradientenstruktur durch einen Brechzahlgradienten gebildet wird mit folgenden Schritten:
(a) Herstellen einer Zusammensetzung aus einem oder mehreren polymerisierbaren oder polykondensierbaren organischen Monomeren und mindestens einer ionischen Flüssigkeit;
(b) Erzeugen einer Potentialdifferenz zur gerichteten Diffusion der Monomere unter Bildung eines Brechzahlgradienten durch Induzierung einer lokalen Polymerisation oder Polykondensation.

2. Verfahren nach Anspruch 1, **dadurch gekennzeichnet, dass** die Potentialdifferenz durch Belichten, vorzugsweise mit UV-Licht oder Laserlicht oder durch Elektronenbestrahlung erzeugt wird.

3. Verfahren nach Anspruch 1 oder 2, **dadurch gekennzeichnet, dass** die Potentialdifferenz durch holographische oder lithographische Techniken erzeugt wird.

4. Verfahren nach einem der vorhergehenden Ansprüche, **dadurch gekennzeichnet, dass** das polymerisierbare oder polykondensierbare organische Monomer oder die polymerisierbaren oder polykondensierbaren organischen Monomere ausgewählt sind aus der Gruppe enthaltend (Meth)acrylsäure und Derivate, (Meth)acrylsäureester und Derivate, (Meth)acrylnitrile, Styrole oder Styrol-Derivate, Alkene, halogenierte Alkene, Vinylacetat, Vinylpyrrolidon oder Vinylcarbazol.

5. Verfahren nach einem der vorhergehenden Ansprüche, **dadurch gekennzeichnet, dass** die Kationen der ionischen Flüssigkeit oder der ionischen Flüssigkeiten ausgewählt sind aus der Gruppe der Ammonium-, Phosphonium-, Uronium-, Thiouronium-, Guanidiniumkationen oder heterocyclischen Kationen.

6. Verfahren nach einem der vorhergehenden Ansprüche, **dadurch gekennzeichnet, dass** die Anionen der ionischen Flüssigkeit oder der ionischen Flüssigkeiten ausgewählt sind aus der Gruppe der Halogenide, Acetate, Aluminate, Phosphate, Phosphinate, Borate, Sulfate, Sulfonate, Imide, Amide, oder Cyanate.

7. Verfahren nach einem der vorhergehenden Ansprüche, **dadurch gekennzeichnet, dass** die Zusammensetzung 0,1 bis 98 Gew.- % eines härtbaren Matrixmaterials aus polymerisierbaren oder polykondensierbaren organischen Monomer und / oder Oligomeren und / oder Prepolymeren oder Vorstufen des härtbaren Matrixmaterials enthält.

8. Verfahren nach Anspruch 7, **dadurch gekennzeichnet, dass** das härtbare Matrixmaterial aus polymerisierbaren oder polykondensierbaren Monomeren und / oder hydrolysierbaren Silanen, welche auch polymerisierbare und / oder polykondensierbare Gruppen aufweisen können, hergestellt wird.

9. Verfahren nach einem der Ansprüche 7 oder 8, **dadurch gekennzeichnet, dass** das härtbare Matrixmaterial ausgewählt ist aus der Gruppe enthaltend Polyurethanharz-Lacke und Polyepoxidharz-Lacke.

10. Verfahren nach einem der Ansprüche 7 bis 9, **dadurch gekennzeichnet, dass** die Zusammensetzung zu einem Formkörper geformt oder auf ein Substrat aufgetragen und vor Aufbau des Brechzahlgradienten thermisch und / oder photochemisch gehärtet wird.

11. Optisches Element mit Gradientenstruktur, wobei die Gradientenstruktur durch einen Brechzahlgradienten gebildet wird, enthaltend folgende Komponenten:
(a) 4,9 bis 98 Gew.-% eines oder mehreren organischer Polymere ausgewählt ist aus der Gruppe enthaltend Poly(meth)acrylsäure und Derivate, Poly(meth)acrylate, Poly(meth)acrylnitrile, Polystyrole oder Polystyrol-Derivate, Polyalkene, halogenierte Polyalkene, Polyvinylacetat, Polyvinylpyrrolidon, Polyvinylcarbazol, Poly(polyethylenglycol)-(meth)acrylate, Poly(polyethylenglycol)di(meth)acrylate,
(b) 0,1 bis 50 Gew.-% mindestens einer ionischen Flüssigkeit,
(c) 0 bis 5 Gew.-% ein oder mehrere Additive ausgewählt aus thermischen oder photochemischen Vernetzungsinitiatoren, Sensibilisierungsmitteln, Netzhilfsmitteln, Haftvermittlern, Verlaufsmitteln, Antioxidationsmitteln, Stabilisatoren, Farbstoffen, photochromen oder thermochromen Verbindungen.

12. Optisches Element nach Anspruch 11, **dadurch gekennzeichnet, dass** das optische Element ein Matrixmaterial aus einem Polymer und/oder einem Kondensat aus einer oder mehreren hydrolysierbaren organisch modifizierten anorganischen Verbindungen umfasst.

13. Optisches Element nach Anspruch 12, **dadurch gekennzeichnet, dass** die härtbare Matrix Polymere enthält ausgewählt aus der Gruppe enthaltend Polyurethanharz-Lacke und Polyepoxidharz-Lacke.

14. Verwendung eines optischen Elementes mit Gradientenstruktur für holographische Anwendungen, planare Gradientenindexlinsen in der abbildenden Optik, Lichtmanagementfolien, Diffusoren, Head-up-Displays, Head-down-Displays, Lichtwellenleiter und optische Datenspeicher, erhältlich nach dem Verfahren eines der Ansprüche 1 bis 10.

## Claims

1. Process for producing optical elements having a gradient structure, in particular for holographic applications, wherein the gradient structure is formed by a refractive index gradient by means of the following steps:
(a) production of a composition by mixing one or more polymerizable or polycondensable organic monomers and at least one ionic liquid;
(b) generation of a potential difference by directed diffusion of the monomers to form a refractive index gradient by initiation of local polymerization or polycondensation.

2. Process according to Claim 1, **characterized in that** the potential difference is generated by illumination, preferably with UV light or laser light or by electron irradiation.

3. Process according to Claim 1 or 2, **characterized in that** the potential difference is generated by holographic or lithographic techniques.

4. Process according to any of the preceding claims, **characterized in that** the polymerizable or polycondensable organic monomer or the polymerizable or polycondensable organic monomers is/are selected from the group consisting of (meth)acrylic acid and derivatives, (meth)acrylic esters and derivatives, (meth)acrylonitriles, styrenes or styrene derivatives, alkenes, halogenated alkenes, vinyl acetate, vinylpyrrolidone and vinylcarbazole.

5. Process according to any of the preceding claims, **characterized in that** the cations of the ionic liquid or the ionic liquids are selected from the group consisting of ammonium, phosphonium, uronium, thiouronium, guanidinium cations and heterocyclic cations.

6. Process according to any of the preceding claims, **characterized in that** the anions of the ionic liquid or the ionic liquids are selected from the group consisting of halides, acetates, aluminates, phosphates, phosphinates, borates, sulfates, sulfonates, imides, amides and cyanates.

7. Process according to any of the preceding claims, **characterized in that** the composition contains from 0.1 to 98% by weight of a curable matrix material composed of polymerizable or polycondensable organic monomers and/or oligomers and/or prepolymers or precursors of the curable matrix material.

8. Process according to Claim 7, **characterized in that** the curable matrix material is produced from polymerizable or polycondensable monomers and/or hydrolysable silanes which may also have polymerizable and/or polycondensable groups.

9. Process according to either Claim 7 or 8, **characterized in that** the curable matrix material is selected from the group consisting of polyurethane resin coatings and polyepoxy resin coatings.

10. Process according to any of Claims 7 to 9, **characterized in that** the composition is shaped to form a molding or applied to a substrate and thermally and/or photochemically cured before formation of the refractive index gradient.

11. Optical element having a gradient structure, where the gradient structure is formed by a refractive index gradient, comprising the following components:
(a) from 4.9 to 98% by weight of one or more organic polymers selected from the group consisting of poly(meth)acrylic acid and derivatives, poly(meth)acrylates, poly(meth)-acrylonitriles, polystyrenes and polystyrene derivatives, polyalkenes, halogenated polyalkenes, polyvinyl acetate, polyvinylpyrrolidone, polyvinylcarbazole, poly(polyethylene glycol) (meth)acrylates, poly(polyethylene glycol) di(meth)acrylates,
(b) from 0.1 to 50% by weight of at least one ionic liquid,
(c) from 0 to 5% by weight of one or more additives selected from among thermal or photochemical crosslinking initiators, sensitizing agents, wetting agents, bonding agents, leveling agents, antioxidants, stabilizers, dyes, photochromic or thermochromic compounds.

12. Optical element according to Claim 11, **characterized in that** the optical element comprises a matrix material composed of a polymer and/or a condensate of one or more hydrolysable organically modified inorganic compounds.

13. Optical element according to Claim 12, **characterized in that** the curable matrix contains polymers selected from the group consisting of polyurethane resin coatings and polyepoxy resin coatings.

14. Use of an optical element having a gradient structure for holographic applications, planar gradient index lenses in imaging optics, light management films, diffusers, head-up displays, head-down displays, optical waveguides and optical data stores, obtainable by the process according to any of Claims 1 to 10.

## Revendications

1. Procédé pour la fabrication d'éléments optiques présentant une structure à gradient, en particulier pour des utilisations holographiques, la structure à gradient étant formée par un gradient d'indices de réfraction, par les étapes suivantes :
(a) préparation d'une composition constituée par un ou plusieurs monomères organiques polymérisables ou polycondensables et au moins un liquide ionique ;
(b) génération d'une différence de potentiel pour la diffusion ciblée des monomères avec formation d'un gradient d'indices de réfraction par induction d'une polymérisation locale ou d'une polycondensation locale.

2. Procédé selon la revendication 1, **caractérisé en ce que** la différence de potentiel est générée par un éclairage, de préférence par de la lumière UV ou laser ou par un rayonnement électronique.

3. Procédé selon la revendication 1 ou 2, **caractérisé en ce que** la différence de potentiel est générée par des techniques holographiques ou lithographiques.

4. Procédé selon l'une quelconque des revendications précédentes, **caractérisé en ce que** le monomère organique polymérisable ou polycondensable ou les monomères organiques polymérisables ou polycondensables est/sont choisis dans le groupe contenant l'acide (méth)acrylique et ses dérivés, les esters de l'acide (méth)acrylique et leurs dérivés, les (méth)acrylonitriles, les styrènes ou les dérivés du styrène, les alcènes, les alcènes halogénés, l'acétate de vinyle, la vinylpyrrolidone ou le vinylcarbazole.

5. Procédé selon l'une quelconque des revendications précédentes, **caractérisé en ce que** les cations du ou des liquide(s) ionique(s) sont choisis dans le groupe des cations d'ammonium, de phosphonium, d'uronium, de thio-uronium, de guanidinium ou hétérocycliques.

6. Procédé selon l'une quelconque des revendications précédentes, **caractérisé en ce que** les anions du ou des liquide(s) ionique(s) sont choisis dans le groupe des halogénures, acétates, aluminates, phosphates, phosphinates, borates, sulfates, sulfonates, imides, amides ou cyanates.

7. Procédé selon l'une quelconque des revendications précédentes, **caractérisé en ce que** la composition contient 0,1 à 98% en poids d'un matériau de matrice durcissable en monomère organique et/ou en oligomères et/ou en prépolymères ou précurseurs polymérisable(s) ou polycondensable(s) du matériau de matrice durcissable.

8. Procédé selon la revendication 7, **caractérisé en ce que** le matériau de matrice durcissable est préparé à partir de monomères polymérisables ou polycondensables et/ou de silanes hydrolysables, qui peuvent également présenter des groupes polymérisables et/ou polycondensables.

9. Procédé selon l'une quelconque des revendications 7 ou 8, **caractérisé en ce que** le matériau de matrice durcissable est choisi dans le groupe contenant les laques de résine de polyuréthane et les laques de résine de polyépoxyde.

10. Procédé selon l'une quelconque des revendications 7 à 9, **caractérisé en ce que** la composition est façonnée en un corps façonné ou appliquée sur un substrat et durcie thermiquement et/ou photochimiquement avant la formation du gradient d'indices de réfraction.

11. Elément optique présentant une structure à gradient, la structure à gradient étant formée par un gradient d'indices de réfraction, contenant les composants suivants :
(a) 4,9 à 98% en poids d'un ou de plusieurs polymères organiques choisis dans le groupe contenant le poly(acide (méth)acrylique) et ses dérivés, les poly(méth)acrylates, les poly(méth)acrylonitriles, les polystyrènes ou les dérivés du polystyrène, les polyalcènes, les polyalcènes halogénés, le poly(acétate de vinyle), la polyvinylpyrrolidone, le polyvinylcarbazole, les poly((méth)acrylates de polyéthylèneglycol), les poly(di(méth)acrylates de polyéthylèneglycol),
(b) 0,1 à 50% en poids d'au moins un liquide ionique,
(c) 0 à 5% en poids d'un ou de plusieurs additifs choisis parmi les initiateurs de réticulation thermiques ou photochimiques, les agents de sensibilisation, les adjuvants de mouillage, les promoteurs d'adhérence, les agents d'étalement, les antioxydants, les stabilisateurs, les colorants, les composés photochromes ou thermochromes.

12. Elément optique selon la revendication 11, **caractérisé en ce que** l'élément optique comprend un matériau de matrice en un polymère et/ou un condensat d'un ou de plusieurs composés inorganiques organiquement modifiés, hydrolysables.

13. Élément optique selon la revendication 12, **caractérisé en ce que** le matériau de matrice durcissable contient des polymères choisis dans le groupe contenant les laques de résine de polyuréthane et les laques de résine de polyépoxyde.

14. Utilisation d'un élément optique présentant une structure à gradient pour des applications holographiques, des lentilles planes à indice à gradient dans l'optique d'imagerie, les feuilles de gestion de la lumière, les diffuseurs, les affichages tête haute, les affichages tête basse, les fibres optiques et les mémoires optiques, pouvant être obtenu selon le procédé selon l'une quelconque des revendications 1 à 10.
